# EUROPEAN PATENT APPLICATION

(11) **EP 2 388 850 A2**
(43) Date of publication of application: **23.11.2011**
(21) Application number: 11164847.3
(22) Date of filing: 04.05.2011
(51) Int. Cl.: H01M 8/24, H01M 8/10, H01M 8/02

(54) **Printed circuit board, fuel cell and method of manufacturing printed circuit board**

(30) Priority: 17.05.2010 JP 2010112802; 10.11.2010 JP 2010252124
(71) Applicant: NITTO DENKO CORPORATION, Ibaraki-shi, Osaka 567-8680 (JP)
(72) Inventor: Hanazono, Hiroyuki, Ibaraki-shi Osaka 567-8680 (JP); Inoue, Shinichi, Ibaraki-shi Osaka 567-8680 (JP); Hasegawa, Mineyoshi, Ibaraki-shi Osaka 567-8680 (JP); Okumura, Keisuke, Ibaraki-shi Osaka 567-8680 (JP); Ebe, Hirofumi, Ibaraki-shi Osaka 567-8680 (JP)
(74) Representative: Gill, Stephen Charles

(57) **Abstract**

An FPC board, electrode films and a fuel accommodating chamber are accommodated in a casing. In the FPC board, a plurality of collector portions are joined onto a base insulating layer with an adhesive pattern sandwiched therebetween. The base insulating layer is made of porous ePTFE, and is air-permeable. Openings are formed in the collector portions. The adhesive pattern has the same shape as the plurality of collector portions. The FPC board is sandwiched by an upper surface portion and a lower surface portion of the casing while being bent along a bend portion. The electrode films are arranged between the plurality of collector portions of the FPC board. The fuel accommodating chamber is provided between the FPC board and the lower surface portion so as to come in contact with the base insulating layer. A liquid fuel is supplied to the fuel accommodating chamber.

## Description

### BACKGROUND OF THE INVENTION

### Field of the Invention

The present invention relates to a printed circuit board, a fuel cell and a method of manufacturing the printed circuit board.

### Description of the Background Art

Batteries that are small in size and have high capacity are desired for mobile equipment such as cellular telephones. Therefore, fuel cells capable of providing higher energy density than conventional batteries such as lithium secondary batteries have been developed. Examples of the fuel cells include a direct methanol fuel cell.

In the direct methanol fuel cell, methanol is decomposed by a catalyst, forming hydrogen ions. The hydrogen ions are reacted with oxygen in the air to generate electrical power. In this case, chemical energy can be converted into electrical energy with extremely high efficiency, so that significantly high energy density can be obtained.

JP 2009-140618 A discloses a liquid fuel supply type fuel cell in which a vaporization membrane, a collector, a negative electrode, an electrolyte film and a positive electrode are arranged in this order. In the liquid fuel supply type fuel cell, a liquid fuel is supplied to the vaporization membrane, so that a fuel gas vaporized at the interface between the vaporization membrane and the liquid fuel passes through the vaporization membrane and reaches the negative electrode.

WO 2008/023634 A1 discloses a fuel cell in which a cathode conductive layer, a power generator, an anode conductive layer, a gas-liquid separation membrane and a fuel accommodating chamber are arranged in this order. In the fuel cell, part of liquid methanol is vaporized in the fuel accommodating chamber, so that the vaporized methanol is sent to the power generator through the gas-liquid separation membrane.

Further, JP 2008-300238 A discloses a fuel cell using a conductor layer of a flexible printed circuit board as a collector. An electrode film composed of a fuel electrode, an air electrode and an electrolyte electrode is arranged between portions of the bent flexible printed circuit board in the inside of the fuel cell of JP 2008-300238 A. The conductor layer as the collector is formed on the base insulating layer in the flexible printed circuit board.

An opening for supplying air and methanol to the base insulating layer is provided in the flexible printed circuit board of JP 2008-300238 A. Further, the foregoing vaporization membrane or the gas-liquid separation membrane need to be arranged on an upper surface of the conductor layer or a lower surface of the base insulating layer in order to supply the vaporized methanol to the electrolyte electrode.

### BRIEF SUMMARY OF THE INVENTION

An object of the present invention is to provide a printed circuit board, a fuel cell and a method of manufacturing the printed circuit board capable of simplifying the configuration of the fuel cell.
(1) According to a first aspect of the present invention, a printed circuit board used in a fuel cell includes an insulating layer that is made of a porous material, an adhesive layer provided on the insulating layer, and a conductor layer provided on the adhesive layer, wherein the conductor layer and the adhesive layer have the same patterns or different patterns.
   In the printed circuit board, the conductor layer is provided on the insulating layer made of the porous material with the adhesive layer sandwiched therebetween. The conductor layer can be used as a collector of the fuel cell. The insulating layer allows a gas to permeate therethrough, and the conductor layer and the adhesive layer have the same patterns or different patterns. Accordingly, the gas or vaporized fuel can be efficiently supplied to a cell element through a region on which the conductor layer and the adhesive layer do not exist without forming an opening in the insulating layer in the fuel cell.
   In addition, the insulating layer can be used for separating the vaporized fuel from the liquid fuel. Thus, the vaporized fuel can be supplied to the cell element without separately providing a gas-liquid separation membrane.
   As described above, the configuration of the fuel cell can be simplified because the printed circuit board has a collecting action and a gas-liquid separating action.
   Furthermore, the conductor layer can adhere to the insulating layer by the adhesive layer, thus preventing the insulating layer having the gas-liquid separating action from being stripped from the conductor layer. This prevents supply efficiency of the vaporized fuel to the cell element from being lowered. As a result, a decrease in power generation efficiency of the fuel cell is prevented, and reliability of the fuel cell is improved.
(2) The patterns of the conductor layer and the adhesive layer may be formed such that the conductor layer and the adhesive layer have a common opening.
   In this case, the gas or the vaporized fuel that have permeated the insulating layer made of the porous material is efficiently supplied to the cell element through the common opening of the conductor layer and the adhesive layer.
(3) The insulating layer may have one surface and the other surface, and have a first region and a second region that are adjacent to each other on the one surface, the insulating layer can be bent at a bend portion between the first region and the second region such that the first region and the second region are opposite to each other, and the conductor layer may include a first conductor portion formed in the first region of the insulating layer, and a second conductor portion formed in the second region of the insulating layer.
   In this case, the insulating layer of the printed circuit board can be bent at the bend portion between the first region and the second region such that the first region and the second region are opposite to each other, and the cell element can be arranged between the first and second conductor portions on the bent insulating layer.
   This allows different gases or different vaporized fuels to be supplied to the first and second regions, respectively, from the other surface of the bent insulating layer. Thus, the gases and the vaporized fuels can be efficiently supplied to the cell element through a region of the first region on which the first conductor portion and the adhesive layer do not exist, and a region of the second region on which the second conductor portion and the adhesive layer do not exist, respectively. As a result, the configuration of the fuel cell can be further simplified.
(4) The printed circuit board may further include a conductive cover layer that covers a surface of the conductor layer.
   In this case, the surface of the conductor layer is covered with the cover layer having conductivity. Thus, the conductor layer can be prevented from corroding without inhibiting the collecting action of the conductor layer in the fuel cell.
(5) The conductor layer may have first and second main surfaces and side surfaces, the cover layer may be formed on each of the first and second main surfaces and the side surfaces of the conductor layer, and the conductor layer may be provided on the insulating layer such that the cover layer is sandwiched between the first main surface and the insulating layer.
   In this case, the conductor layer can be more reliably prevented from corroding in the fuel cell.
(6) The adhesive layer may be made of a photosensitive material.
   Thus, the photosensitive material is subjected to exposure and development, so that the adhesive layer having the pattern can be easily formed. Accordingly, the printed circuit board can be easily manufactured at lower cost.
(7) According to another aspect of the present invention, a fuel cell includes a printed circuit board, a cell element, and a housing that accommodates the printed circuit board and the cell element, wherein the printed circuit board includes an insulating layer that is made of a porous material, an adhesive layer provided on the insulating layer, and a conductor layer provided on the adhesive layer, the conductor layer and the adhesive layer have the same patterns or different patterns, the insulating layer has one surface and the other surface, and has a first region and a second region that are adjacent to each other on the one surface, the insulating layer can be bent at a bend portion between the first region and the second region such that the first region and the second region are opposite to each other, the conductor layer includes a first conductor portion formed in the first region of the insulating layer, and a second conductor portion formed in the second region of the insulating layer, and the cell element is arranged between the first conductor portion and the second conductor portion while the first region and the second region of the insulating layer of the printed circuit board are bent along the bend portion with the one surface as an inner side.
   In the fuel cell, the printed circuit board and the cell element are accommodated in the housing. The cell element is arranged between the first and second conductor portions on the insulating layer that is bent at the bend portion.
   In the printed circuit board, the conductor layer is provided on the insulating layer made of the porous material with the adhesive layer sandwiched therebetween. The conductor layer can be used as a collector of the fuel cell. The insulating layer allows a gas to permeate therethrough, and the conductor layer and the adhesive layer have the same patterns or different patterns. Thus, gases and vaporized fuels can be efficiently supplied to the cell element through a region of the first region on which the first conductor portion and the adhesive layer do not exist, and a region of the second region on which the second conductor portion and the adhesive layer do not exist, respectively, without forming an opening in the insulating layer.
   In addition, the insulating layer can be used for separating the vaporized fuel from a liquid fuel. Thus, the vaporized fuel can be supplied to the cell element without separately providing a gas-liquid separation membrane.
   As described above, the configuration of the fuel cell can be simplified because the printed circuit board has a collecting action and a gas-liquid separating action.
   Furthermore, the conductor layer can adhere to the insulating layer by the adhesive layer, thus preventing the insulating layer having the gas-liquid separating action from being stripped from the conductor layer. This prevents supply efficiency of the vaporized fuel to the cell element from being lowered. As a result, a decrease in power generation efficiency of the fuel cell is prevented, and reliability of the fuel cell is improved.
   The printed circuit board of the fuel cell can be a printed circuit board of the first aspect of the present invention.
(8) According to still another aspect of the present invention, a method of manufacturing a printed circuit board used in a fuel cell includes the steps of preparing a base material having a laminated structure of a support layer and a conductor layer, forming a conductor pattern having a given pattern on one surface of the support layer by processing the conductor layer, forming an adhesive pattern made of an adhesive layer having the same pattern as or a different pattern from the pattern of the conductor layer on the conductor pattern, joining an insulating layer that is made of a porous material on the conductor pattern with the adhesive pattern sandwiched between the insulating layer and the conductor pattern, and stripping the support layer from the conductor pattern.
   In the method of manufacturing the printed circuit board, the base material having the laminated structure of the support layer and the conductor layer is prepared, and the conductor pattern having the given pattern is formed on the one surface of the support layer by processing the conductor layer. Then, the adhesive pattern composed of the adhesive layer having the pattern that is same as or different from the pattern of the conductor layer is formed on the conductor pattern, and the insulating layer made of the porous material is joined onto the conductor pattern with the adhesive pattern sandwiched therebetween. After that, the support layer is stripped from the conductor pattern.
   The printed circuit board manufactured in the foregoing manner includes the insulating layer made of the porous material, the adhesive pattern provided on the insulating layer, and the conductor pattern provided on the adhesive pattern. The conductor pattern and the adhesive pattern have the same patterns or different patterns.
   In this case, the conductor pattern can be used as a collector of the fuel cell. The insulating layer allows a gas to permeate therethrough, and the conductor layer and the adhesive layer have the same patterns or different patterns. Thus, in the fuel cell, the gas or vaporized fuel can be efficiently supplied to a cell element through a region on which the conductor pattern and the adhesive pattern do not exist without forming an opening in the insulating layer.
   In addition, the insulating layer can be used for separating the vaporized fuel from a liquid fuel. Thus, the vaporized fuel can be supplied to the cell element without separately providing a gas-liquid separation membrane.
   As described above, the configuration of the fuel cell can be simplified because the printed circuit board manufactured by the method of manufacturing the printed circuit board has a collecting action and a gas-liquid separating action.
   Furthermore, the insulating layer is joined onto the conductor pattern with the adhesive pattern sandwiched therebetween, thus preventing the conductor pattern from being stripped from the insulating layer in the method of manufacturing the printed circuit board.
   When the adhesive pattern and the conductor pattern have the same shape, the adhesive pattern is not formed in an exposed region of the insulating layer that does not overlap the conductor pattern. This prevents the printed circuit board from being degraded in flexibility.
   The method may be used to manufacture a printed circuit board of the first aspect of the present invention.
(9) The adhesive layer may be photosensitive, the step of forming the adhesive pattern may include the steps of forming the adhesive layer on the support layer to cover the conductor pattern, and forming the adhesive pattern by subjecting the adhesive layer to exposure processing and development processing.
   In this case, the adhesive pattern can be easily formed by subjecting the adhesive layer to the exposure processing and the development processing.
(10) According to yet another aspect of the present invention, a method of manufacturing a printed circuit board used in a fuel cell includes the steps of preparing a base material having a laminated structure of a support layer and a conductor layer, forming an adhesive pattern composed of an adhesive layer having a given pattern on the conductor layer, forming the conductor pattern by removing an exposed region of the conductor layer using the adhesive pattern as a mask, joining an insulating layer that is made of a porous material on the conductor pattern with the adhesive pattern sandwiched between the insulating layer and the conductor pattern, and stripping the support layer from the conductor pattern.
   In the method of manufacturing the printed circuit board, the base material having the laminated structure of the support layer and the conductor layer is prepared, and the adhesive pattern composed of the adhesive layer having the given pattern is formed on the conductor layer. Then, the conductor pattern is formed by removing the exposed region of the conductor layer using the adhesive pattern as the mask, and the insulating layer made of the porous material is joined onto the conductor pattern with the adhesive pattern sandwiched therebetween. After that, the support layer is stripped from the conductor pattern.
   The printed circuit board manufactured in the foregoing manner includes the insulating layer made of the porous material, the adhesive pattern provided on the insulating layer, and the conductor pattern provided on the adhesive pattern. The conductor pattern and the adhesive pattern have the common pattern.
   In this case, the conductor pattern can be used as a collector of the fuel cell. The insulating layer allows a gas to permeate therethrough, and the conductor layer and the adhesive layer have the common pattern. Thus, in the fuel cell, the gas or vaporized fuel can be efficiently supplied to a cell element through a region on which the conductor pattern and the adhesive pattern do not exist without forming an opening in the insulating layer.
   In addition, the insulating layer can be used for separating the vaporized fuel from a liquid fuel. Thus, the vaporized fuel can be supplied to the cell element without separately providing a gas-liquid separation membrane.
   As described above, the configuration of the fuel cell can be simplified because the printed circuit board manufactured by the method of manufacturing the printed circuit board has a collecting action and a gas-liquid separating action.
   Furthermore, the conductor pattern is formed by using the adhesive pattern as the mask in the method of manufacturing the printed circuit board. This allows the conductor pattern to be formed without separately preparing a mask pattern. As a result, manufacturing steps and manufacturing cost of the printed circuit board can be reduced.
   The method may be used to manufacture a printed circuit board of the first aspect of the present invention.
(11) The adhesive layer may be photosensitive, and the step of forming the adhesive pattern on the conductor layer may include the step of forming the adhesive pattern by subjecting the adhesive layer to exposure processing and development processing.
   In this case, the adhesive pattern can be easily formed by subjecting the adhesive layer to the exposure processing and the development processing.
(12) According to still another aspect of the present invention, a method of manufacturing a printed circuit board used in a fuel cell includes the steps of preparing a base material having a laminated structure of a support layer and a conductor layer, forming the conductor pattern on one surface of the support layer by processing the conductor layer, forming a laminated structure of an adhesive layer and an insulating layer that is made of a porous material on the conductor pattern, stripping the support layer from the conductor pattern, and forming an adhesive pattern having a given pattern by removing an exposed region of the adhesive layer that does not overlap the conductor pattern after stripping the support layer.
   In the method of manufacturing the printed circuit board, the base material having the laminated structure of the support layer and the conductor layer is prepared, and the conductor pattern is formed on the one surface of the support layer by processing the conductor layer. Then, the laminated structure of the adhesive layer and the insulating layer made of the porous material is formed on the conductor pattern, and the support layer is stripped from the conductor pattern. After the support layer is stripped, the exposed region of the adhesive layer that does not overlap the conductor pattern is removed. Thus, the adhesive pattern having the given pattern is formed. The printed circuit board manufactured in the foregoing manner includes the insulating layer made of the porous material, the adhesive pattern provided on the insulating layer, and the conductor pattern provided on the adhesive pattern. The conductor pattern and the adhesive pattern have the common pattern.
   In this case, the conductor pattern can be used as a collector of the fuel cell. The insulating layer allows a gas to permeate therethrough, and the conductor layer and the adhesive layer have the common pattern. Thus, in the fuel cell, the gas or vaporized fuel can be efficiently supplied to a cell element through a region on which the conductor pattern and the adhesive pattern do not exist without forming an opening in the insulating layer.
   In addition, the insulating layer can be used for separating the vaporized fuel from a liquid fuel. Thus, the vaporized fuel can be supplied to the cell element without separately providing a gas-liquid separation membrane.
   As described above, the configuration of the fuel cell can be simplified because the printed circuit board manufactured by the method of manufacturing the printed circuit board has a collecting action and a gas-liquid separating action.
   Furthermore, since the conductor pattern can be used as a mask, the adhesive pattern can be formed without separately preparing a mask pattern in the method of manufacturing the printed circuit board. As a result, manufacturing steps and manufacturing cost of the printed circuit board can be reduced.
   The method may be used to manufacture a printed circuit board of the first aspect of the present invention.
(13) The step of removing the exposed region of the adhesive layer that does not overlap the conductor pattern may include the step of removing the exposed region of the adhesive layer using plasma.
   In this case, the given pattern can be easily formed in the adhesive layer regardless of whether the adhesive layer is photosensitive or non-photosensitive.
   Other features, elements, characteristics, and advantages of the present invention will become more apparent from the following description of preferred embodiments of the present invention with reference to the attached drawings.

### BRIEF DESCRIPTION OF THE SEVERAL VIEWS OF THE DRAWINGS

Fig. 1 (a) is a plan view of an FPC board according to a first embodiment, and Fig. 1 (b) is a sectional view of the FPC board taken along the line A-A of Fig. 1 (a);
Figs. 2 (a) to (d) are sectional views for illustrating steps in a method of manufacturing the FPC board;
Figs. 3 (a) to (d) are sectional views for illustrating steps in the method of manufacturing the FPC board;
Figs. 4 (a) to (c) are sectional views for illustrating steps in the method of manufacturing the FPC board;
Fig. 5 is an external perspective view of a fuel cell using the FPC board;
Fig. 6 is a diagram for explaining actions in the fuel cell;
Figs. 7 (a) to (d) are sectional views for illustrating steps in a method of manufacturing an FPC board according to a second embodiment;
Figs. 8 (a) to (d) are sectional views for illustrating steps in the method of manufacturing the FPC board according to the second embodiment;
Figs. 9 (a) to (e) are sectional views for illustrating steps in a method of manufacturing an FPC board according to a third embodiment;
Figs. 10 (a) and (b) are a plan view and a sectional view of an FPC board according to a fourth embodiment;
Figs. 11 (a) to (c) are sectional views for illustrating steps in a method of manufacturing the FPC board according to the fourth embodiment;
Figs. 12 (a) to (d) are sectional views for illustrating steps in the method of manufacturing the FPC board according to the fourth embodiment;
Figs. 13 (a) to (c) are sectional views for illustrating steps in the method of manufacturing the FPC board according to the fourth embodiment;
Figs. 14 (a) to (c) are sectional views for illustrating steps in the method of manufacturing the FPC board according to the fourth embodiment;
Fig. 15 is a perspective view of a carrier layer, a first laminate, an aligning member and a second laminate;
Figs. 16 (a) to (d) are sectional views of the carrier layer, the first laminate, the aligning member, the second laminate and fixing members; and
Figs. 17 (a) to (e) are sectional views for illustrating steps in a method of manufacturing an FPC board according to a fifth embodiment.

### DETAILED DESCRIPTION OF THE INVENTION

### [1] First Embodiment

Description will be made of a printed circuit board, a fuel cell and a method of manufacturing a printed circuit board according to a first embodiment while referring to the drawings. In the present embodiment, a flexible printed circuit board (hereinafter abbreviated as an FPC board) having bending characteristics is described as an example of the printed circuit board. The FPC board is used in the fuel cell.

### (1) Configuration of the FPC Board

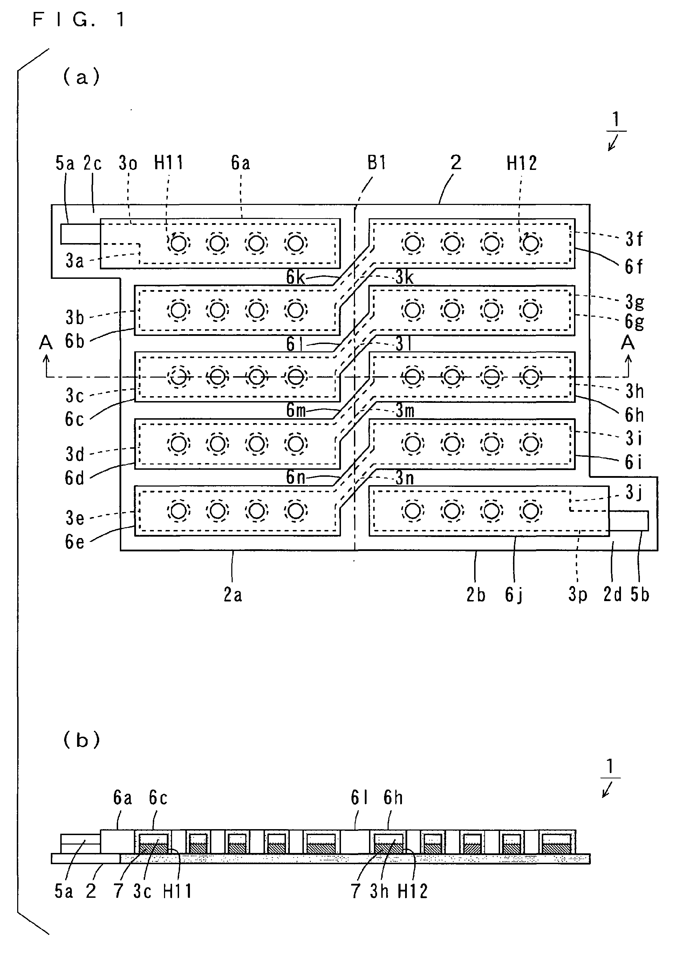

Fig. 1 (a) is a plan view of the FPC board according to the first embodiment, and Fig. 1 (b) is a sectional view of the FPC board taken along the line A-A of Fig. 1 (a).

As shown in Figs. 1 (a) and (b), the FPC board 1 includes a base insulating layer 2 made of porous ePTFE (expanded polytetrafluoroethylene), for example. This causes the base insulating layer 2 to be air-permeable. The base insulating layer 2 is composed of a first insulating portion 2a, a second insulating portion 2b, a third insulating portion 2c and a fourth insulating portion 2d. The first insulating portion 2a and the second insulating portion 2b each have a rectangular shape, and integrally formed while being adjacent to each other. Hereinafter, sides that are parallel to a border line between the first insulating portion 2a and the second insulating portion 2b are referred to as lateral sides, and a pair of sides that are perpendicular to the lateral sides of the first insulating portion 2a and the second insulating portion 2b are referred to as end sides.

The third insulating portion 2c is formed to extend outward from part of the lateral side at a corner of the first insulating portion 2a. The fourth insulating portion 2d is formed to extend outward from part of the lateral side at a corner of the second insulating portion 2b on the diagonal position of the foregoing corner of the first insulating portion 2a.

A bend portion B1 is provided on the border line between the first insulating portion 2a and the second insulating portion 2b so as to divide the base insulating layer 2 into two substantially equal parts. As will be described below, the base insulating layer 2 can be bent along the bend portion **B1**. The bend portion B1 may be a shallow groove with a line shape, a mark with a line shape or the like, for example. Alternatively, there may be nothing at the bend portion B1 if the base insulating layer 2 can be bent at the bend portion **B1**. When the base insulating layer 2 is bent along the bend portion **B1**, the first insulating portion 2a and the second insulating portion 2b are opposite to each other. In this case, the third insulating portion 2c and the fourth insulating portion 2d are not opposite to each other.

Rectangular collector portions 3a, 3b, 3c, 3d, 3e, 3f, 3g, 3h, 3i, 3j, connection conductor portions 3k, 3l, 3m, 3n and drawn-out conductor portions 3o, 3p are formed on one surface of the base insulating layer 2 with an adhesive pattern 7 of Fig. 1 (b) sandwiched therebetween. The collector portions 3a to 3j, the connection conductor portions 3k to 3n and the drawn-out conductor portions 3o, 3p are made of copper, for example.

Any adhesive such as an epoxy resin adhesive, a phenolic resin adhesive, a polyester resin adhesive, an acrylic resin adhesive or a polyimide adhesive is used as the adhesive pattern 7. In the present embodiment, a photo-acid generating agent is added to the adhesive pattern 7, thus causing the adhesive pattern 7 to be photosensitive.

Each of the collector portions 3a to 3j has a rectangular shape. The collector portions 3a to 3e extend parallel to the end sides of the first insulating portion 2a, and arranged along a direction of the lateral sides of the first insulating portion 2a. Similarly, the collector portions 3f to 3j extend parallel to the end sides of the second insulating portion 2b, and arranged along a direction of the lateral sides of the second insulating portion 2b. In this case, the collector portions 3a to 3e and the collector portions 3f to 3j are symmetrically arranged with respect to the bend portion **B1**.

Each of the connection conductor portions 3k to 3n is formed on the first insulating portion 2a and the second insulating portion 2b so as to cross the bend portion **B1**. The connection conductor portion 3k electrically connects the collector portion 3b and the collector portion 3f to each other, the connection conductor portion 3l electrically connects the collector portion 3c and the collector portion 3g to each other, the connection conductor portion 3m electrically connects the collector portion 3d and the collector portion 3h to each other, and the connection conductor portion 3n electrically connects the collector portion 3e and the collector portion 3i to each other.

A plurality of (four in this example) openings H11 are formed along a direction of the end sides in each of the collector portions 3a to 3e. A plurality of (four in this example) openings H12 are formed along the direction of the end sides in each of the collector portions 3f to 3j.

The drawn-out conductor portion 3o is formed to linearly extend from an outer short side of the collector portion 3a to the third insulating portion 2c. The drawn-out conductor portion 3p is formed to linearly extend from an outer short side of the collector portion 3j to the fourth insulating portion 2d.

A cover layer 6a is formed on the first insulating portion 2a to cover the collector portion 3a and part of the drawn-out conductor potion 3o. Thus, the tip of the drawn-out conductor portion 3o is exposed while not covered with the cover layer 6a. The exposed portion of the drawn-out conductor portion 3o is referred to as a drawn-out electrode 5a. Cover layers 6b, 6c, 6d, 6e are formed on the first insulating portion 2a to cover the collector portions 3b to 3e, respectively. The cover layers 6a to 6e come in contact with an upper surface of the first insulating portion 2a inside the openings H11 of the collector portions 3a to 3e.

A cover layer 6j is formed on the second insulating portion 2b to cover the collector portion 3j and part of the drawn-out conductor potion 3p. Thus, the tip of the drawn-out conductor portion 3p is exposed while not covered with the cover layer 6j. The exposed portion of the drawn-out conductor portion 3p is referred to as a drawn-out electrode 5b. Cover layers 6f, 6g, 6h, 6i are formed on the second insulating portion 2b to cover the collector portions 3f to 3i, respectively. The cover layers 6f to 6j come in contact with an upper surface of the second insulating portion 2b inside the openings H12 of the collector portions 3f to 3j.

Cover layers 6k, 61, 6m, 6n are formed on the first insulating portion 2a and the second insulating portion 2b to cover the connection conductor portions 3k to 3n, respectively. Each of the cover layers 6a to 6n is made of a resin composition containing a conductive material and having corrosion resistance.

For example, phenolic resin, epoxy resin, acrylic resin, polyurethane resin, polyimide resin, polyamide imide resin, polyester resin or a mixture of at least two types of the foregoing resin can be used as the resin composition.

The resin composition preferably has moisture permeability of not more than 150 g/(m²·24h) in an environment at a temperature of 40 °C and with a relative humidity of 90 %. The resin composition preferably has a glass transition temperature Tg of not less than 60 °C.

Meanwhile, a metal material such as gold (Au), silver or silver nanoparticles, a carbon material such as carbon black, graphite or carbon nanotube, a conductive polymeric material such as polythiophene or polyaniline, or a mixture of at least two types of the foregoing materials can be used as the conductive material, for example.

In this case, even though acid such as methanol used as a fuel is in contact with the FPC board 1, the collector portions 3a to 3j, the connection conductor portions 3k to 3n, and the drawn-out conductor portions 3o, 3p can be prevented from corroding without inhibiting the collecting action in the fuel cell using the FPC board 1.

Particularly, when the foregoing carbon material is used as the conductive material, an expensive material such as gold may not be used. This prevents corrosion of the collector portions 3a to 3j, the connection conductor portions 3k to 3n and the drawn-out conductor portions 3o, 3p at lower cost.

### (2) Method of Manufacturing the FPC Board

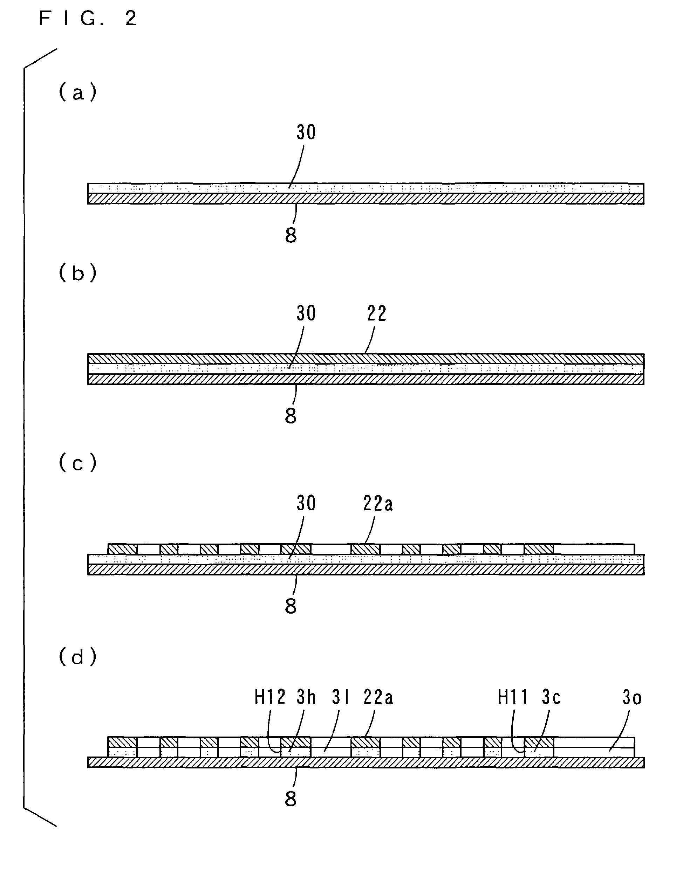

Next, description will be made of a method of manufacturing the FPC board 1 shown in Fig. 1. Figs. 2, 3 and 4 show sectional views, which correspond to the sectional view taken along the line A-A of Fig. 1, for use in illustrating steps in the method of manufacturing the FPC board 1.

First, a two-layer base material composed of a carrier layer 8 and a conductor layer 30 is prepared as shown in Fig. 2 (a). Resin such as PET (polyethylene terephthalate) having a pressure sensitive adhesive layer or a thin metal film such as stainless steel having a pressure sensitive adhesive layer can be used as the carrier layer 8. The conductor layer 30 is made of copper, for example. The carrier layer 8 and the conductor layer 30 may be attached to each other by a laminator or subjected to contact bonding by a pressing machine. Contact bonding of the carrier layer 8 and the conductor layer 30 may be performed in a heated state or a vacuum state.

As shown in Fig. 2 (b), a resist film 22 is formed of a photosensitive dry film resist or the like on the conductor layer 30, for example. As shown in Fig. 2 (c), the resist film 22 is exposed in a given pattern, followed by development, thereby forming an etching resist pattern 22a.

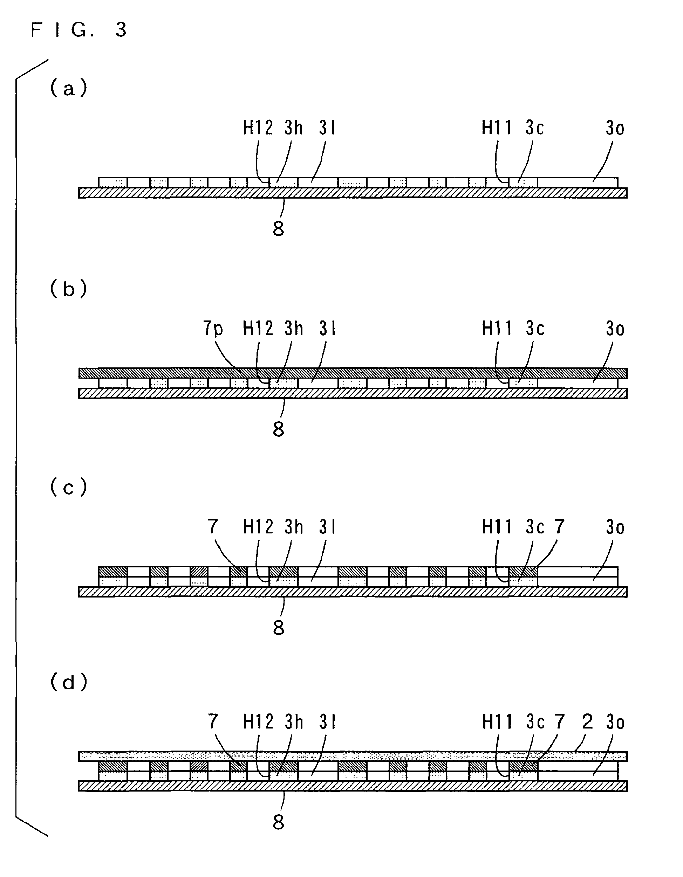

Next, a region of the conductor layer 30 that is exposed while not covered with the etching resist pattern 22a is removed by etching using ferric chloride as shown in Fig. 2 (d). The etching resist pattern 22a is then removed by a stripping solution as shown in Fig. 3 (a). Thus, the collector portions 3a to 3j, the connection conductor portions 3k to 3n and the drawn-out conductor portions 3o, 3p (see Fig. 1 (a)) are formed on the carrier layer 8. The plurality of openings H11 are formed in the collector portions 3a to 3e, and the plurality of openings H12 are formed in the collector portions 3f to 3j.

The collector portions 3a to 3j, the connection conductor portions 3k to 3n and the drawn-out conductor portions 3o, 3p may be formed on the carrier layer 8 by another method such as sputtering, evaporation or plating.

Then, an adhesive layer precursor 7p is applied on the entire surface including the top surfaces (surfaces not in contact with the carrier layer 8) of the collector portions 3a to 3j, the connection conductor portions 3k to 3n and the drawn-out conductor portions 3o, 3p as shown in Fig. 3 (b). As shown in Fig. 3 (c), the adhesive layer precursor 7p is exposed with a given mask pattern sandwiched therebetween, followed by development, so that the adhesive pattern 7 having the given pattern is formed on the collector portions 3a to 3j, the connection conductor portions 3k to 3n and the drawn-out conductor portions 3o, 3p.

When the adhesive layer precursor 7p is negative photosensitive, the adhesive layer precursor 7p is exposed with the mask pattern having an inverted shape of the collector portions 3a to 3j, the connection conductor portions 3k to 3n and the drawn-out conductor portions 3o, 3p sandwiched therebetween. When the adhesive layer precursor 7p is positive photosensitive, the adhesive layer precursor 7p is exposed with the mask pattern having the same shape as the collector portions 3a to 3j, the connection conductor portions 3k to 3n and the drawn-out conductor portions 3o, 3p sandwiched therebetween.

When the adhesive layer precursor 7p is positive photosensitive, the adhesive layer precursor 7p may be exposed from its lower surface (surface in contact with the collector portions 3a to 3j, the connection conductor portions 3k to 3n and the drawn-out conductor portions 3o, 3p). In this case, the collector portions 3a to 3j, the connection conductor portions 3k to 3n and the drawn-out conductor portions 3o, 3p can be used as the mask pattern, thus eliminating the need to use a separate mask pattern. Note that the carrier layer 8 made of PET transmits exposure light, and therefore does not inhibit the adhesive layer precursor 7p from being exposed from its lower surface (surface in contact with the collector portions 3a to 3j, the connection conductor portions 3k to 3n and the drawn-out conductor portions 3o, 3p).

The applied adhesive layer precursor 7p excluding its portions on the collector portions 3a to 3j, the connection conductor portions 3k to 3n and the drawn-out conductor portions 3o, 3p may be removed by a chemical solution, laser light or plasma processing. In this case, the mask pattern may not be used in exposure of the adhesive layer precursor 7p. Similarly, the adhesive layer precursor 7p may be applied only on the collector portions 3a to 3j, the connection conductor portions 3k to 3n and the drawn-out conductor portions 3o, 3p by screen printing or a paste dispenser. Also in this case, the mask pattern may not be used in exposure of the adhesive layer precursor 7p.

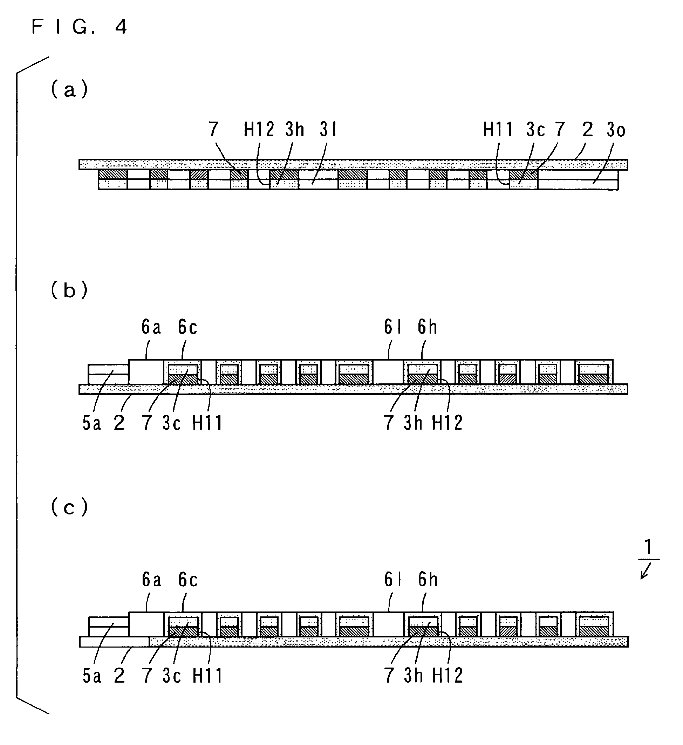

Next, the base insulating layer 2 is joined onto the collector portions 3a to 3j, the connection conductor portions 3k to 3n and the drawn-out conductor portions 3o, 3p with the adhesive pattern 7 sandwiched therebetween as shown in Fig. 3 (d). The carrier layer 8 is subsequently stripped from the collector portions 3a to 3j, the connection conductor portions 3k to 3n and the drawn-out conductor portions 3o, 3p as shown in Fig. 4 (a).

Then, the cover layers 6a to 6n (see Fig. 1 (a)) are formed by application or lamination on the base insulating layer 2 to cover the collector portions 3a to 3j, the connection conductor portions 3k to 3n and the drawn-out conductor portions 3o, 3p as shown in Fig. 4 (b). Here, the drawn-out electrodes 5a, 5b (see Fig. 1 (a)) are exposed while not covered with the cover layers 6a, 6j. The top-to-bottom direction in the sectional views of Figs. 4 (b) and (c) is the reverse of that in the sectional view of Fig. 4 (a).

Finally, the base insulating layer 2 is cut in a given shape, so that the FPC board 1 including the base insulating layer 2, the collector portions 3a to 3j, the connection conductor portions 3k to 3n, the drawn-out conductor portions 3o, 3p and the cover layers 6a to 6n is completed as shown in Fig. 4 (c).

The thickness of the carrier layer 8 is preferably not less than 10 µm and not more than 200 µm, and more preferably not less than 25 µm and not more than 100 µm. The carrier layer 8 having the thickness of not less than 10 µm improves its handleability, and the carrier layer 8 having the thickness of not more than 200 µm improves its flexibility. In the present embodiment, the thickness of the carrier layer 8 is 35 µm.

The thickness of the conductor layer 30 is preferably not less than 2 µm and not more than 70 µm, and more preferably not less than 5 µm and not more than 35 µm. The conductor layer 30 having the thickness of not less than 2 µm improves electrical characteristics of resistances or the like, and the conductor layer 30 having the thickness of not more than 70 µm improves its handleability. In the present embodiment, the thickness of the conductor layer 30 is 25 µm.

The thickness of the adhesive pattern 7 is preferably not less than 5 µm and not more than 100 µm, and more preferably not less than 15 µm and not more than 50 µm. The adhesive pattern 7 having the thickness of not less than 5 µm improves the adhesive force of the adhesive, and the adhesive pattern 7 having the thickness of not more than 100 µm improves its handleability. In the present embodiment, the thickness of the adhesive layer 7 is 25 µm.

The thickness of the base insulating layer 2 is preferably not less than 10 µm and not more than 500 µm, and more preferably not less than 35 µm and not more than 150 µm. The base insulating layer 2 having the thickness of not less than 10 µm improves its handleability, and the base insulating layer 2 having the thickness of not more than 500 µm reduces its cost. As described above, the base insulating layer 2 is made of porous ePTFE.

The diameter (pore size) of each of the plurality of holes included in the base insulating layer 2 is preferably not less than 0.03 µm and not more than 100 µm, and more preferably not less than 0.1 µm and not more than 50 µm. In the present embodiment, the thickness of the base insulating layer 2 is 75 µm, and the pore size of each of the plurality of holes included in the base insulating layer 2 is 1 µm.

While the FPC board 1 is manufactured by a subtractive method in Figs. 2 to 4, the present invention is not limited to this. For example, another manufacturing method such as a semi-additive method may be used.

### (3) Fuel Cell Using the FPC Board

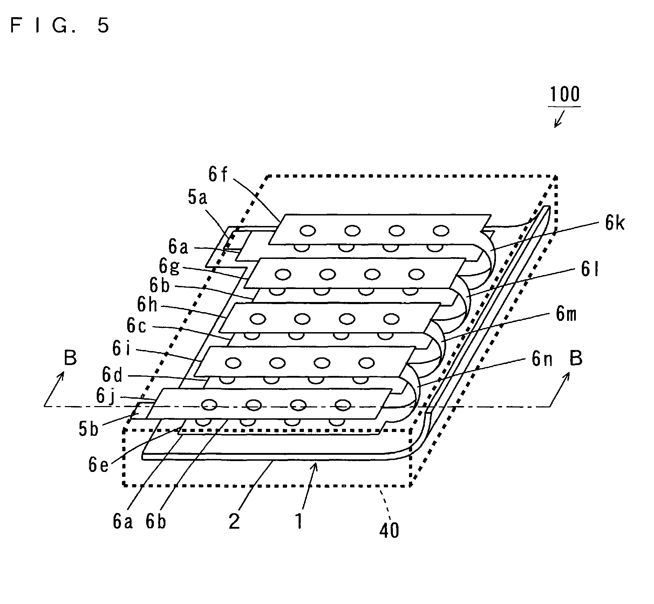

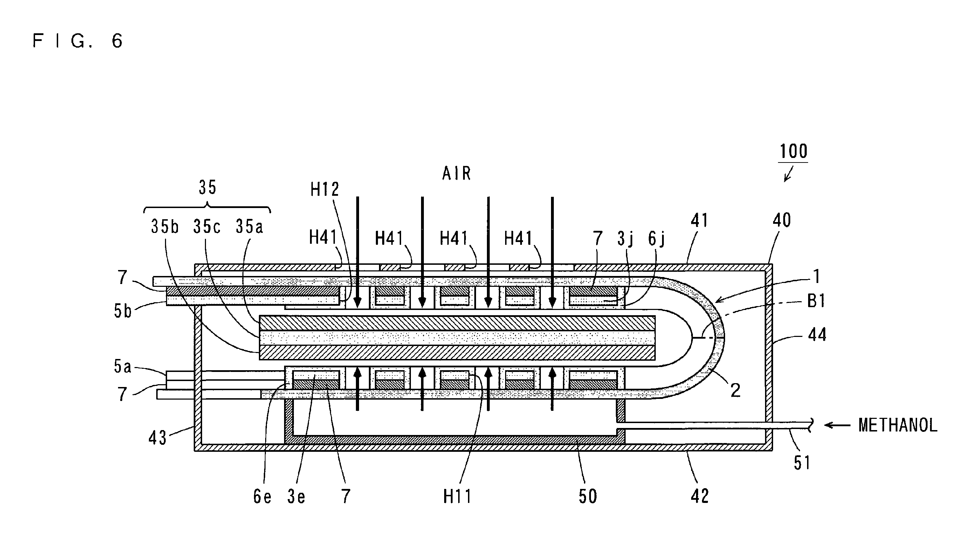

Fig. 5 is an external perspective view of a fuel cell 100 using the FPC board 1. Fig. 6 is a diagram for use in illustrating actions in the fuel cell 100, and is a sectional view taken along the line B-B of the fuel cell 100 of Fig. 5.

As shown in Figs. 5 and 6, the fuel cell 100 has a casing 40 having a rectangular parallelpiped shape. The casing 40 is indicated by the dotted lines in Fig. 5. The casing 40 has an upper surface portion 41, a lower surface portion 42, one side surface portion 43 and the other side surface portion 44. Fig. 6 does not show the remaining pair of side surface portions.

The FPC board 1 is sandwiched between the upper surface portion 41 and the lower surface portion 42 of the casing 40 while being bent along the bend portion B1 of Fig. 1 such that the one surface, on which the cover layers 6a to 6n are formed, is positioned on an inner side.

The drawn-out electrodes 5a, 5b of the FPC board 1 are drawn out from the one side surface portion 43 of the casing 40 to the outside. Terminals of various external circuits are electrically connected to the drawn-out electrodes 5a, 5b.

Inside the casing 40, a plurality of (five in the present embodiment) electrode films 35 are arranged between the cover layer 6a and the cover layer 6f, between the cover layer 6b and the cover layer 6g, between the cover layer 6c and the cover layer 6h, between the cover layer 6d and the cover layer 6i, and between the cover layer 6e and the cover layer 6j, respectively, of the bent FPC board 1 (see Fig. 1 (a)). This causes the plurality of electrode films 35 to be connected in series.

Each electrode film 35 is composed of an air electrode 35a, a fuel electrode 35b and an electrolyte film 35c. The air electrode 35a is formed on one surface of the electrolyte film 35c, and the fuel electrode 35b is formed on the other surface of the electrolyte film 35c. The air electrodes 35a of the plurality of electrode films 35 are opposite to the cover layers 6f to 6j of the FPC board 1, respectively, and the fuel electrodes 35b of the plurality of electrode films 35 are opposite to the cover layers 6a to 6e of the FPC board 1, respectively.

A plurality of openings H41 are formed on the upper surface portion 41 of the casing 40 to correspond to the plurality of openings H12, respectively, of the collector portions 3f to 3j. Air is supplied to the air electrodes 35a of the electrode films 35 through the plurality of openings H41 of the casing 40, the air-permeable base insulating layer 2 of the FPC board 1 and the plurality of openings H12 of the collector portions 3f to 3j.

A fuel accommodating chamber 50 is provided at the lower surface portion 42 of the casing 40 to come in contact with the first insulating portion 2a (see Fig. 1 (a)) of the base insulating layer 2. One end of a fuel supply pipe 51 is connected to the fuel accommodating chamber 50. The other end of the fuel supply pipe 51 is connected to a fuel supplier (not shown) in the outside through the other side surface portion 44 of the casing 40. Fuel is supplied from the fuel supplier to the fuel accommodating chamber 50 through the fuel supply pipe 51. In the present embodiment, liquid methanol is used as the fuel.

The FPC board 1 according to the present embodiment functions as a gas-liquid separation membrane. Part of methanol is vaporized in the fuel accommodating chamber 50, so that the vaporized methanol is supplied to the fuel electrodes 35b of the electrode films 35 through the air-permeable base insulating layer 2 of the FPC board 1 and the plurality of openings H11 of the collector portions 3a to 3e.

In the above-described configuration, methanol is decomposed into hydrogen ions and carbon dioxide in the plurality of fuel electrodes 35b, forming electrons. The formed electrons are led from the collector portion 3a (see Fig. 1) to the drawn-out electrode 5a of the FPC board 1. Hydrogen ions decomposed from methanol permeate through the electrolyte films 35c to reach the air electrodes 35a. In the plurality of air electrodes 35a, hydrogen ions and oxygen are reacted while electrons led from the drawn-out electrode 5b to the collector portion 3j are consumed, thereby forming water. In this manner, electrical power is supplied to the external circuits connected to the drawn-out electrodes 5a, 5b.

### (4) Effects

In the FPC board 1 according to the present embodiment, the collector portions 3a to 3j, the connection conductor portions 3k to 3n and the drawn-out conductor portions 3o, 3p are provided on the base insulating layer 2 made of porous ePTFE with the adhesive pattern 7 sandwiched therebetween. The base insulating layer 2 is air-permeable, and the adhesive pattern 7 has the same shape as the collector portions 3a to 3j, the connection conductor portions 3k to 3n and the drawn-out conductor portions 3o, 3p. Accordingly, air and vaporized methanol can be efficiently supplied to the electrode films 35 through the portions of the base insulating layer 2 overlapping the plurality of openings H11, H12 (the regions of the base insulating layer 2 in which the adhesive pattern 7 and the collector portions do not exist) without forming openings in the base insulating layer 2 of the FPC board 1 in the fuel cell 100.

In addition, the base insulating layer 2 can be used for separating the vaporized methanol from the liquid methanol. Thus, the vaporized methanol can be supplied to the air electrode 35 without separately providing a gas-liquid separation membrane.

As described above, since the FPC board 1 has the collecting action and the gas-liquid separating action, the configuration of the fuel cell 100 can be simplified.

In the fuel cell 100 according to the present embodiment, the plurality of electrode films 35 are arranged inside the base insulating layer 2 that is bent at the bend portion B1. This causes air to be supplied to the air electrodes 35a of the electrode films 35 through the base insulating layer 2 and the plurality of openings H12 of the collector portions 3f to 3j. The vaporized methanol is supplied to the fuel electrodes 35b of the electrode films 35 through the base insulating layer 2 and the plurality of openings H11 of the collector portions 3a to 3e. In this manner, the air and the vaporized methanol can be efficiently supplied to the air electrodes 35a and the fuel electrodes 35b of the electrode films 35. Accordingly, the configuration of the fuel cell 100 is further simplified.

In the method of manufacturing the FPC board 1 according to the present embodiment, the base insulating layer 2 does not exist when the collector portions 3a to 3j, the connection conductor portions 3k to 3n and the drawn-out conductor portions 3o, 3p are formed, and the base insulating layer 2 is joined onto the collector portions 3a to 3j, the connection conductor portions 3k to 3n and the drawn-out conductor portions 3o, 3p after the collector portions 3a to 3j, the connection conductor portions 3k to 3n and the drawn-out conductor portions 3o, 3p are formed. Therefore, the base insulating layer 2 is prevented from being dissolved or deformed by the chemical solution such as an etching solution because of the formation of the collector portions 3a to 3j, the connection conductor portions 3k to 3n and the drawn-out conductor portions 3o, 3p. This does not limit the type of the material used for the base insulating layer 2. As a result, the base insulating layer 2 can be formed using various materials depending on uses.

The base insulating layer 2 is joined onto the collector portions 3a to 3j, the connection conductor portions 3k to 3n and the drawn-out conductor portions 3o, 3p with the adhesive pattern 7 sandwiched therebetween, thus reliably preventing the collector portions 3a to 3j, the connection conductor portions 3k to 3n and the drawn-out conductor portions 3o, 3p from being stripped from the base insulating layer 2. Accordingly, power generation efficiency is prevented from being lowered in the fuel cell 100 including the FPC board 1. This results in improved reliability of the fuel cell 100.

Since the adhesive pattern 7 has the same shape as the collector portions 3a to 3j, the connection conductor portions 3k to 3n and the drawn-out conductor portions 3o, 3p, the adhesive pattern 7 is not formed in a region of the base insulating layer 2 that is exposed while not covered with the collector portions 3a to 3j, the connection conductor portions 3k to 3n and the drawn-out conductor portions 3o, 3p. This prevents flexibility of the FPC board 1 from being degraded. Furthermore, when air and vaporized methanol permeate the base insulating layer 2 to be supplied to the air electrodes 35a and the fuel electrodes 35b, permeation of the air and vaporized methanol is not inhibited by the adhesive layer.

The shape or dimension of at least part of the adhesive pattern 7 may be different from that of the collector portions 3a to 3j, the connection conductor portions 3k to 3n and the drawn-out conductor portions 3o, 3p if the collector portions 3a to 3j, the connection conductor portions 3k to 3n and the drawn-out conductor portions 3o, 3p are reliably joined onto the base insulating layer 2 and the adhesive layer does not inhibit permeation of the air and the vaporized methanol.

Since the adhesive layer precursor 7p is photosensitive, the adhesive pattern 7 can be easily formed by performing the exposure processing and the development processing in the present embodiment.

According to the method of manufacturing the FPC board 1 according to the present embodiment, a base insulating layer 2 made of a transparent material can be also used. In this case, the FPC board 1 can be used as an electrode of a solar battery.

### [2] Second Embodiment

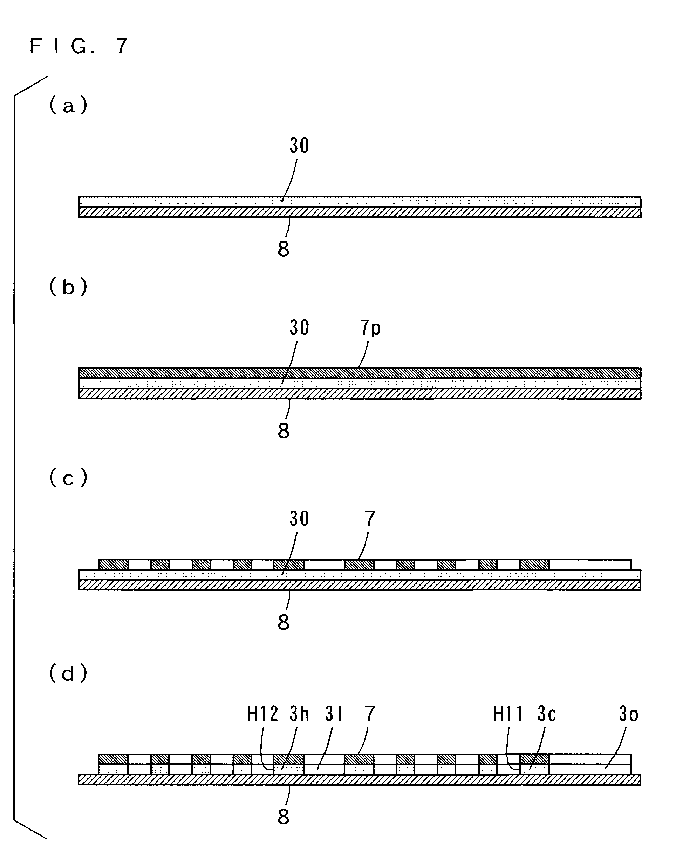

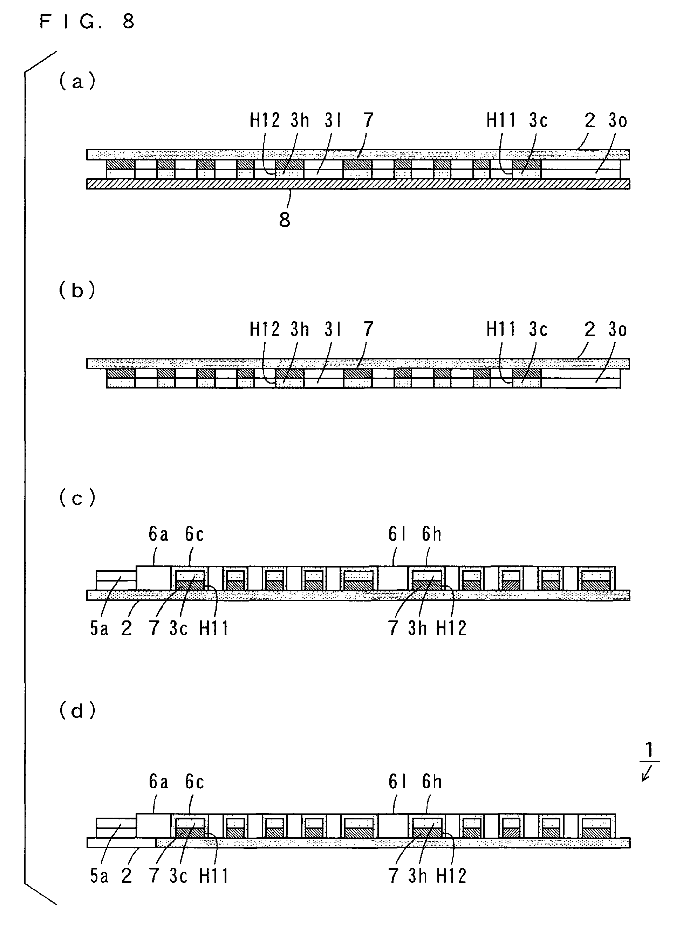

Description will be made of a method of manufacturing the FPC board 1 according to a second embodiment by referring to differences from the method of manufacturing the FPC board 1 according to the first embodiment. Figs. 7 and 8 are sectional views for use in illustrating steps in the method of manufacturing the FPC board 1 according to the second embodiment.

First, the two-layer base material composed of the carrier layer 8 and the conductor layer 30 is prepared as shown in Fig. 7 (a). Next, the adhesive layer precursor 7p is applied onto the conductor layer 30 as shown in Fig. 7 (b). The adhesive layer precursor 7p is exposed with the mask pattern having the same shape as the collector portions 3a to 3j, the connection conductor portions 3k to 3n and the drawn-out conductor portions 3o, 3p of Fig. 1 (a) sandwiched therebetween, followed by development, so that the adhesive pattern 7 having the given pattern is formed on the conductor layer 30 as shown in Fig. 7 (c).

As shown in Fig. 7 (d), the region of the conductor layer 30 that is exposed while not covered with the adhesive pattern 7 is subsequently removed by etching using ferric chloride. Thus, the collector portions 3a to 3j, the connection conductor portions 3k to 3n and the drawn-out conductor portions 3o, 3p (see Fig. 1 (a)) are formed on the carrier layer 8. The plurality of openings H11 are formed in the collector portions 3a to 3e, and the plurality of openings H12 are formed in the collector portions 3f to 3j.

Then, the base insulating layer 2 is joined onto the collector portions 3a to 3j, the connection conductor portions 3k to 3n and the drawn-out conductor portions 3o, 3p with the adhesive pattern 7 sandwiched therebetween as shown in Fig. 8 (a). After that, the carrier layer 8 is stripped from the collector portions 3a to 3j, the connection conductor portions 3k to 3n and the drawn-out conductor portions 3o, 3p as shown in Fig. 8 (b).

The cover layers 6a to 6n (see Fig. 1 (a)) are formed by application or lamination on the base insulating layer 2 to cover the collector portions 3a to 3j, the connection conductor portions 3k to 3n and the drawn-out conductor portions 3o, 3p as shown in Fig. 8 (c). Here, the drawn-out electrodes 5a, 5b (see Fig. 1 (a)) are exposed while not covered with the cover layers 6a, 6j. The top-to-bottom direction in the sectional views of Figs. 8 (c) and (d) is the reverse of that in the sectional view of Fig. 8 (b).

Finally, the base insulating layer 2 is cut in the given shape, so that the FPC board 1 including the base insulating layer 2, the collector portions 3a to 3j, the connection conductor portions 3k to 3n, the drawn-out conductor portions 3o, 3p and the cover layers 6a to 6n is completed as shown in Fig. 8 (d).

In the method of manufacturing the FPC board 1 according to the present embodiment, the adhesive pattern 7 is formed on the conductor layer 30 of the base material having the laminated structure of the carrier layer 8 and the conductor layer 30. The exposed region of the conductor layer 30 is removed using the adhesive pattern 7 as the mask. This allows the collector portions 3a to 3j, the connection conductor portions 3k to 3n and the drawn-out conductor portions 3o, 3p to be formed without separately preparing the mask pattern. This results in reduction in manufacturing steps and cost of the FPC board 1.

Since the adhesive pattern 7 is photosensitive, the adhesive pattern 7 can be easily formed by performing the exposure processing and the development processing.

### [3] Third Embodiment

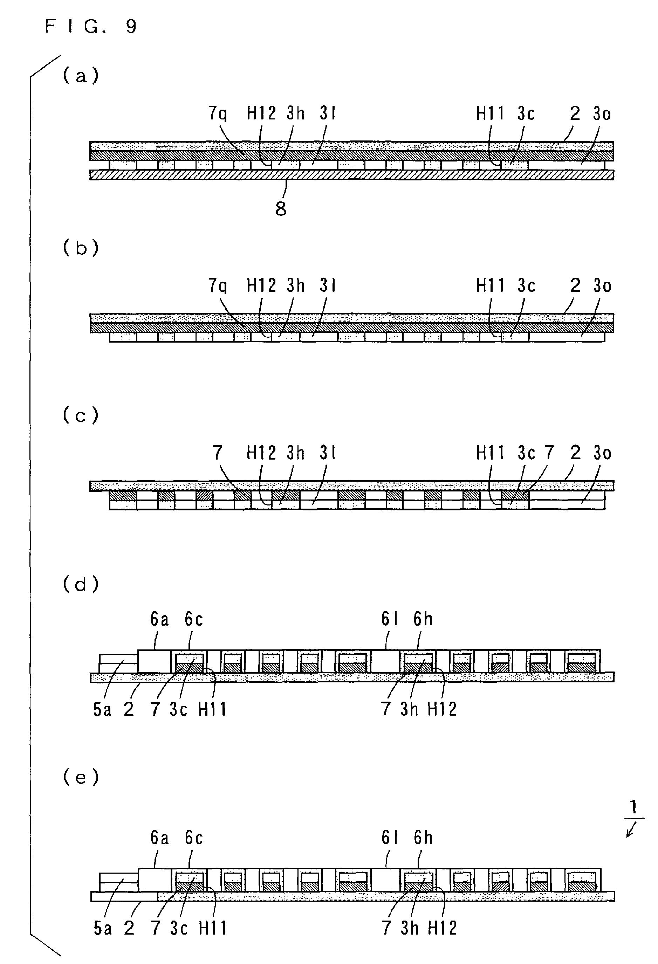

Description will be made of a method of manufacturing the FPC board 1 according to a third embodiment while referring to differences from the method of manufacturing the FPC board 1 according to the first embodiment. In the present embodiment, the adhesive pattern 7 is not photosensitive. Fig. 9 shows sectional views for use in illustrating steps in the method of manufacturing the FPC board according to the third embodiment. The steps shown in Fig. 2 (a) to Fig. 3 (b) of the method of manufacturing the FPC board 1 according to the first embodiment also apply to the method of manufacturing the FPC board 1 according to the present embodiment.

After the step shown in Fig. 3 (b), an adhesive layer 7q is formed by drying the adhesive layer precursor 7p, and the base insulating layer 2 is joined onto the collector portions 3a to 3j, the connection conductor portions 3k to 3n and the drawn-out conductor portions 3o, 3p with the adhesive layer 7q sandwiched therebetween as shown in Fig. 9 (a). The carrier layer 8 is then stripped from the collector portions 3a to 3j, the connection conductor portions 3k to 3n and the drawn-out conductor portions 3o, 3p as shown in Fig. 9 (b). A region of the adhesive layer 7q that is exposed while not overlapping the collector portions 3a to 3j, the connection conductor portions 3k to 3n and the drawn-out conductor portions 3o, 3p is subsequently removed by plasma processing as shown in Fig. 9 (c). In this manner, the adhesive pattern 7 is formed.

Next, the cover layers 6a to 6n (see Fig. 1 (a)) are formed by application or lamination on the base insulting layer 2 to cover the collector portions 3a to 3j, the connection conductor portions 3k to 3n and the drawn-out conductor portions 3o, 3p as shown in Fig. 9 (d). Here, the drawn-out electrodes 5a, 5b (see Fig. 1 (a)) are exposed while not covered with the cover layers 6a, 6j. The top-to-bottom direction in the sectional views of Figs. 9 (d) and (e) is the reverse of that in the sectional view of Fig. 9 (c).

Finally, the base insulating layer 2 is cut in the given shape, so that the FPC board 1 including the base insulating layer 2, the collector portions 3a to 3j, the connection conductor portions 3k to 3n, the drawn-out conductor portions 3o, 3p and the cover layers 6a to 6n is completed as shown in Fig. 9 (e).

Since the collector portions 3a to 3j, the connection conductor portions 3k to 3n and the drawn-out conductor portions 3o, 3p can be used as the mask, the adhesive pattern 7 can be formed without separately preparing the mask pattern in the method of manufacturing the FPC board 1 according to the present embodiment. This results in reduction in the manufacturing steps and cost of the FPC board 1.

The adhesive pattern 7 is formed by the plasma processing. Therefore, the adhesive pattern 7 can be easily formed regardless of whether the adhesive layer precursor 7p is photosensitive or non-photosensitive.

### [4] Fourth Embodiment

Description will be made of an FPC board 1 according to a fourth embodiment by referring to differences from the FPC board 1 according to the first embodiment.

### (1) Configuration of the FPC Board

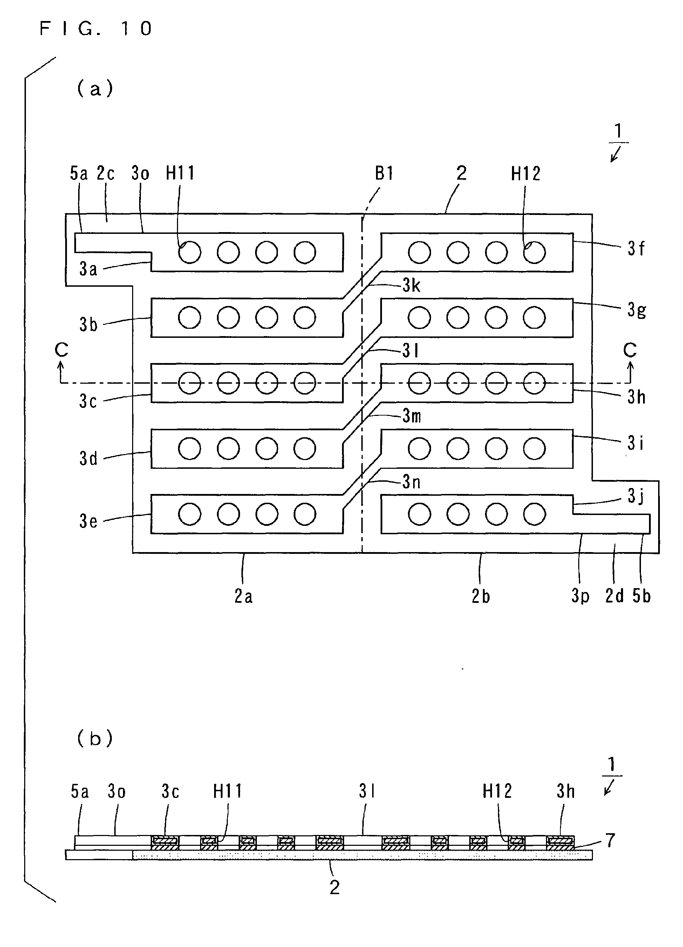

Fig. 10 (a) is a plan view of the FPC board according to the fourth embodiment, and Fig. 10 (b) is a sectional view of the FPC board taken along the line C-C of Fig. 10 (a).

In the FPC board 1 of Figs. 10 (a) and (b), the rectangular collector portions 3a, 3b, 3c, 3d, 3e, 3f, 3g, 3h, 3i, 3j, the connection conductor portions 3k, 31, 3m, 3n and the drawn-out conductor portions 3o, 3p are formed on the one surface of the base insulating layer 2 with the adhesive layer precursor 7p sandwiched therebetween. Each of the collector portions 3a to 3j, the connection conductor portions 3k to 3n and the drawn-out conductor portions 3o, 3p has the configuration in which copper is plated with silver, for example, as described below.

Tips of the drawn-out conductor portions 3o, 3p can be electrically connected to terminals of various external circuits. The tips of the drawn-out conductor portions 3o, 3p are referred to as the drawn-out electrodes 5a, 5b, respectively.

### (2) Method of Manufacturing the FPC Board

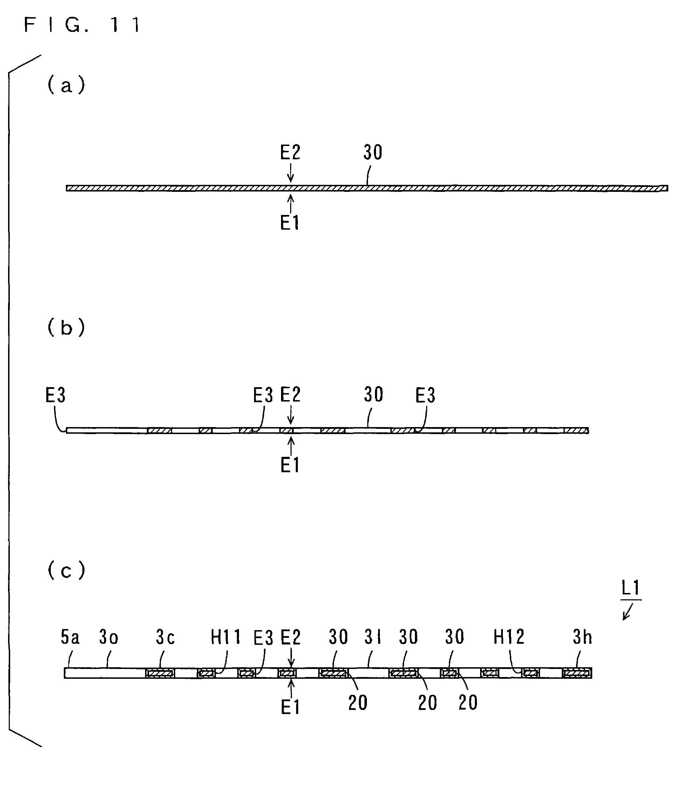

Next, description will be made of a method of manufacturing the FPC board 1 shown in Fig. 10. Figs. 11 to 14 are sectional views for illustrating steps in the method of manufacturing the FPC board 1. Figs. 11 to 14 are sectional views in a portion corresponding to the cross section taken along the line C-C of the FPC board 1 of Fig. 10.

First, the conductor layer 30 made of copper, for example, is prepared as shown in Fig. 11(a). The conductor layer 30 has main surfaces E1, E2. The thickness of the conductor layer 30 is 35 µm, for example. Next, the conductor layer 30 is formed in a given pattern by lasering as shown in Fig. 11 (b). The conductor layer 30 may be formed in the given pattern by etching or punching using a mold instead of lasering.

Then, a plating layer 20 is formed on the main surfaces E1, E2 and side surfaces E3 of the conductor layer 30 having the given pattern as shown in Fig. 11 (c). Here, the side surfaces E3 include outer peripheral surfaces of the conductor layer 30 and inner peripheral surfaces of openings. The plating layer 20 has higher corrosion resistance to formic acid than the conductor layer 30. In the present embodiment, the plating layer 20 is formed by electroless silver plating. Moreover, the plating layer 20 is subjected to electroless nickel plating, not shown, as a barrier layer before the electroless silver plating. In this manner, the cover layer can be easily formed on the main surfaces E1, E2 and the side surfaces E3 of the conductor layer 30 by plating.

The collector portions 3a to 3j, the connection conductor portions 3k to 3n, the drawn-out conductor portions 3o, 3p and the drawn-out electrodes 5a, 5b of Fig. 1 are formed of the conductor layer 30 and the plating layer 20 having the given pattern. The plurality of openings H11, H12 are formed in the collector portions 3a to 3j. Fig. 11 (c) only shows the collector portions 3c, 3h, the connection conductor portion 31, the drawn-out conductor portion 3o and the drawn-out electrode 5a. A laminate composed of the collector portions 3a to 3j, the connection conductor portions 3k to 3n, the drawn-out conductor portions 3o, 3p and the drawn-out electrodes 5a, 5b formed in the foregoing manner is referred to as a first laminate L1.

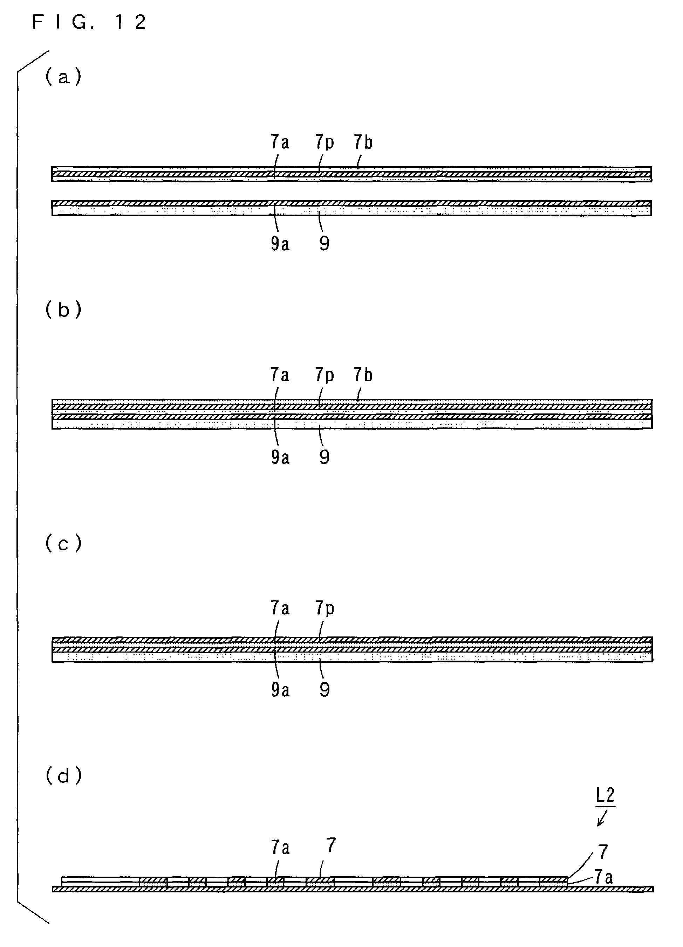

The adhesive layer precursor 7p and a carrier layer 9 are prepared as shown in Fig. 12 (a) concurrently with the step of forming the first laminate L1 of Figs. 11 (a) to (c). Strip layers 7a, 7b are provided on one surface and the other surface of the adhesive layer precursor 7p, respectively. PET (polyethyleneterephthalate), for example, is used as the material for the strip layers 7a, 7b. A pressure sensitive adhesive layer 9a is provided on one surface of the carrier layer 9. PET, for example, is used as the material for the carrier layer 9. An acrylic adhesive, for example, is used as the material for the pressure sensitive adhesive layer 9a.

The adhesive layer precursor 7p and the carrier layer 9 are attached to each other with the strip layer 7a and the pressure sensitive adhesive layer 9a sandwiched therebetween as shown in Fig. 12 (b). The strip layer 7b is then stripped from the adhesive layer precursor 7p as shown in Fig. 12 (c).

After that, the adhesive layer precursor 7p and the strip layer 7a are formed in a given pattern by lasering as shown in Fig. 12 (d). Instead of lasering, the adhesive layer precursor 7p and the strip layer 7a may be formed in the given pattern by etching or punching using a mold. This causes the adhesive pattern 7 to be formed. A laminate composed of the adhesive pattern 7, the strip layer 7a, the pressure sensitive layer 9a and the carrier layer 9 formed in the foregoing manner is referred to as a second laminate L2. The adhesive pattern 7 has the same shape as the pattern of the first laminate L1 of Fig. 11 (c).

The shape or dimension of at least part of the adhesive pattern 7 may be different from the pattern of the first laminate L1 of Fig. 11 (c) if the collector portions 3a to 3j, the connection conductor portions 3k to 3n and the drawn-out conductor portions 3o, 3p reliably adhere to the base insulating layer 2, and permeation of air and vaporized methanol is not inhibited by the adhesive pattern 7.

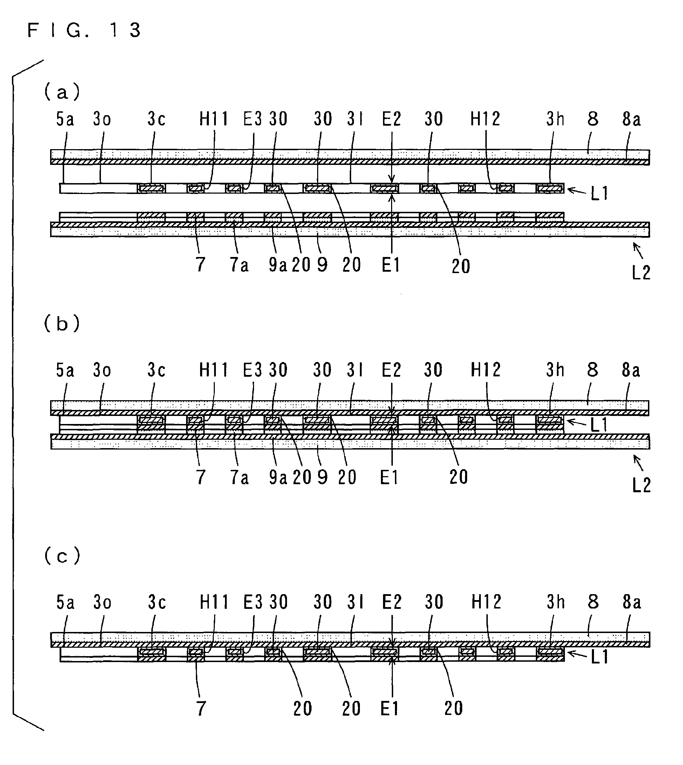

Next, as shown in Fig. 13 (a), the carrier layer 8 is prepared in addition to the first laminate L1 of Fig. 11 (c) and the second laminate L2 of Fig. 12 (d). A pressure sensitive adhesive layer 8a is provided on one surface of the carrier layer 8. PET, for example, is used as the material for the carrier layer 8. An acrylic adhesive, for example, is used as the material for the pressure sensitive adhesive layer 8a.

Then, as shown in Fig. 13 (b), one surface of the first laminate L1 (the surface of the plating layer 20 on the main surface E1 of the conductor layer 30) is attached to the second laminate L2 with the adhesive pattern 7 sandwiched therebetween, and the other surface of the first laminate L1 (the surface of the plating layer 20 on the main surface E2 of the conductor layer 30) is attached to the carrier layer 8 with the pressure sensitive adhesive layer 8a sandwiched therebetween. After that, the strip layer 7a is stripped together with the pressure sensitive adhesive layer 9a and the carrier layer 9 from the second laminate L2 as shown in Fig. 13 (c). Accordingly, the adhesive pattern 7 remains on the one surface of the first laminate L1.

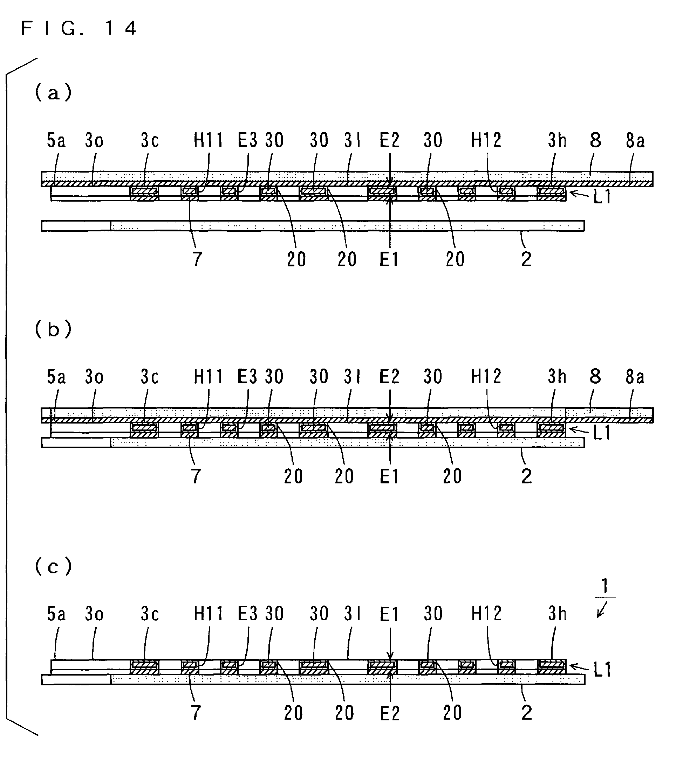

The base insulating layer 2 of Fig. 1 is then prepared as shown in Fig. 14 (a). The base insulating layer 2 is then attached to the one surface of the first laminate L1 (the surface of the plating layer 20 on the main surface E1 of the conductor layer 30) with the adhesive pattern 7 sandwiched therebetween as shown in Fig. 14 (b). After that, the pressure sensitive adhesive layer 8a and the carrier layer 8 are removed from the first laminate L1 as shown in Fig. 14 (c). Accordingly, the FPC board 1 is completed.

In this manner, the first laminate L1 is attached to the one surface of the base insulating layer 2 with the adhesive pattern 7 sandwiched therebetween. Thus, the plating layer 20 on the main surface E1 of the conductor layer 30 can be reliably joined to the one surface of the base insulating layer 2.

Since the shape of the adhesive pattern 7 corresponds to the pattern of the conductor layer 30, the adhesive pattern 7 is not formed in an exposed region of the base insulating layer 2 that is not covered with the conductor layer 30. This prevents the FPC board 1 from being degraded in flexibility. Further, air permeability of the base insulating layer 2 can be ensured.

The thickness of the conductor layer 30 (see Fig. 11 (a)) is preferably not more than 500 µm, and more preferably not less than 1 µm and not more than 100 µm. The conductor layer 30 having the thickness of not more than 500 µm improves its handleability. While copper is used as the material for the conductor layer 30 in this example, nickel, aluminum, silver, gold or an alloy of those metals may be used instead of copper.

While silver is used as the material for the plating layer 20 (see Fig. 11 (c)) in this example, platinum, tungsten, titanium, zirconium or gold may be used instead of silver. While nickel is used as the material for the barrier layer, nickel copper may be used instead of nickel, or the barrier layer may not be provided. When the barrier layer is provided, the thickness of the barrier layer is preferably not less than 0.1 µm and not more than 10 µm, more preferably not less than 0.3 µm and not more than 8 µm, and further preferably not less than 0.3 µm and not more than 5 µm. The barrier layer having the thickness of not less than 0.1 µm improves adhesion between the conductor layer 30 and the plating layer 20, and the barrier layer having the thickness of not more than 10 µm improves conductivity between the conductor layer 30 and the plating layer 20.

The thickness of the adhesive pattern 7 (see Figs. 12 to 14) is preferably not less than 1 µm and not more than 100 µm, and more preferably not less than 10 µm and not more than 50 µm. The adhesive pattern 7 having the thickness of not less than 1 µm improves the adhesive force of the adhesive, and the adhesive pattern 7 having the thickness of not more than 100 µm improves its handleability.

The thickness of each of the carrier layers 8, 9 (see Fig. 13) is preferably not less than 1 µm and not more than 500 µm, and more preferably not less than 25 µm and not more than 250 µm. The carrier layers 8, 9 each having the thickness of not less than 1 µm improves their handleability, and the carrier layers 8, 9 each having the thickness of not more than 500 µm improves their flexibility.

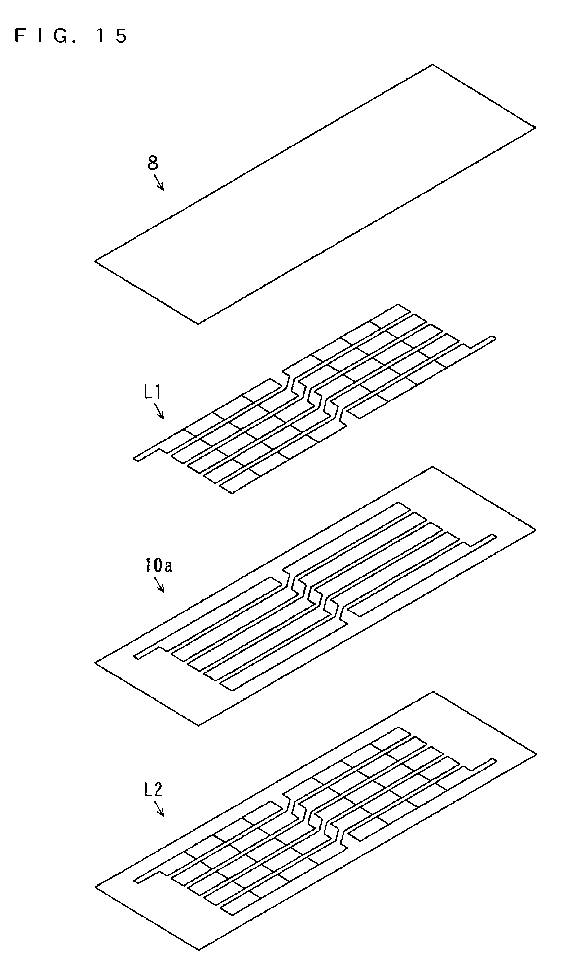

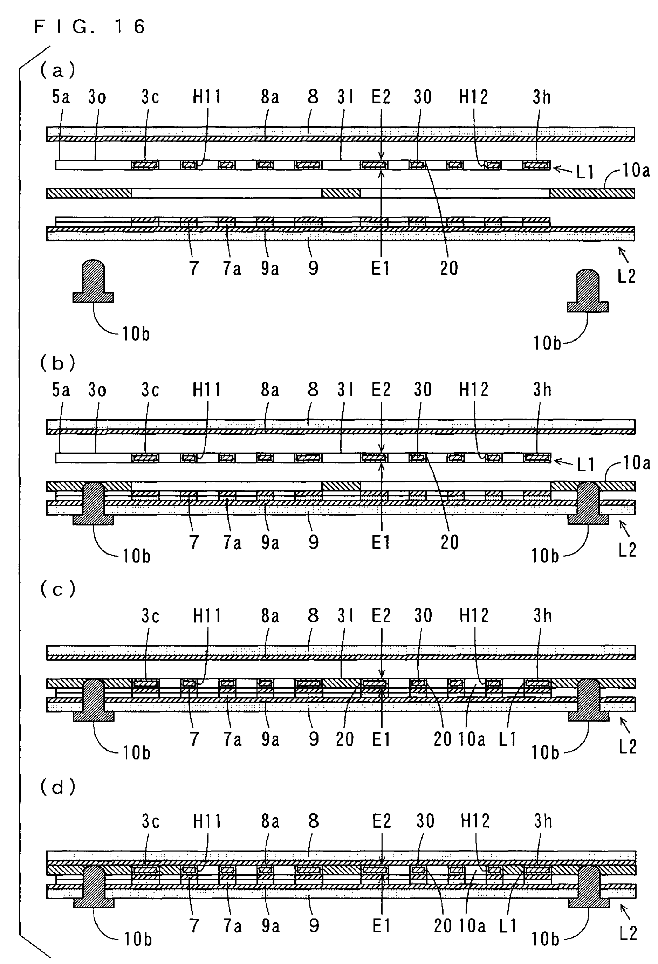

The first laminate L1 may be aligned between the carrier layer 8 and the second laminate L2 using an aligning member and fixing members in the step of attaching the first laminate L1 of Fig. 13 (b) to the carrier layer 8 and the second laminate L2. Fig. 15 is a perspective view of the carrier layer 8, the first laminate L1, an aligning member 10a and the second laminate L2. Fig. 16 is a sectional view of the carrier layer 8, the first laminate L1, the aligning member 10a, the second laminate L2 and fixing members 10b.

As shown in Fig. 15, the aligning member 10a is a plate-shaped member having an inverted pattern of the first laminate L1 excluding portions of the openings H11, H12 (see Fig. 13). This allows the first laminate L1 to be fitted with the aligning member 10a. The thickness of the aligning member 10a is substantially equal to the thickness of the first laminate L1. Therefore, when the first laminate L1 is fitted with the aligning member 10a, the one surface of the first laminate L1 (the surface of the plating layer 20 on the main surface E1 of the conductor layer 30) and the one surface of the aligning member 10a are in the same plane, and the other surface of the first laminate L1 (the surface of the plating layer 20 on the main surface E2 of the conductor layer 30) and the other surface of the aligning member 10a are in the same plane.

As shown in Fig. 16 (a), the aligning member 10a and the fixing members 10b are arranged in addition to the carrier layer 8, the first laminate L1 and the second laminate L2 of Fig. 13 (a). The pressure sensitive adhesive layer 8a is provided on the one surface of the carrier layer 8. The aligning member 10a is subsequently fixed on the second laminate L2 by the fixing members 10b as shown in Fig. 16 (b). The fixing members 10b are pins, for example. Thus, the adhesive pattern 7 of the second laminate L2 is not covered with the pattern of the aligning member 10a to be exposed.

Next, the first laminate L1 is fitted with the aligning member 10a on the second laminate L2, and the one surface of the first laminate L1 (the surface of the plating layer 20 on the main surface E1 of the conductor layer 30) is attached to the second laminate L2 with the adhesive pattern 7 that is not covered with the aligning member 10a to be exposed sandwiched therebetween as shown in Fig. 16 (c). Thus, the first laminate L1 is aligned on the second laminate L2. The carrier layer 8 is subsequently attached to the other surface of the first laminate L1 (the surface of the plating layer 20 on the main surface E2 of the conductor layer 30) with the pressure sensitive adhesive layer 8a sandwiched therebetween.

After that, the fixing members 10b are removed, and the step of manufacturing the FPC board proceeds to the step shown in Fig. 13 (b). The aligning member 10a is removed after the step of Fig. 13 (c), for example.

### (3) Effects

In the FPC board 1 according to the present embodiment, the conductive and corrosion-resistant plating layer 20 is formed on the main surfaces E1, E2 and the side surfaces E3 of the conductor layer 30 having the given pattern. The conductor layer 30 is provided on the base insulating layer 2 such that the plating layer 20 is sandwiched between the main surface E1 and the base insulating layer 2. Accordingly, the plating layer 20 prevents the main surfaces E1, E2 and the side surfaces E3 of the conductor layer 30 from corroding while maintaining the conductivity of the conductor layer 30.

The conductor layer 30 is formed of copper, and the plating layer 20 is formed of silver having higher corrosion resistance to formic acid than copper. Thus, the plating layer 20 sufficiently prevents the conductor layer 30 from corroding even when a by-product of the fuel cell 100 such as formic acid comes in contact with the FPC board 1.

The porous base insulating layer 2 has continuous pores. The plating layer 20 prevents the by-product of the fuel cell 100 such as formic acid from adhering to the conductor layer 30 even though the by-product flows toward the conductor layer 30 through the continuous pores of the base insulating layer 2. As a result, the conductor layer 30 is prevented from corroding.

In this manner, the FPC board 1 according to the present embodiment is used in the fuel cell 100, thereby preventing collection efficiency of the electrodes in the fuel cell 100 from being reduced. This results in improved reliability and longer life of the fuel cell 100.

### [5] Fifth Embodiment

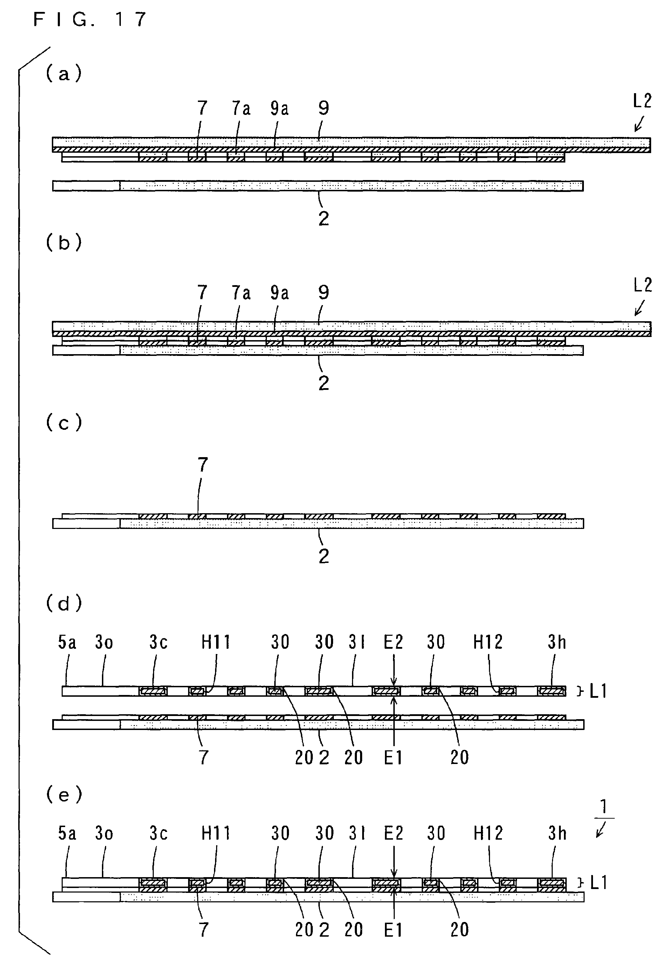

Description will be made of a method of manufacturing an FPC board 1 according to a fifth embodiment by referring to differences from the method of manufacturing the FPC board 1 according to the fourth embodiment. Fig. 17 shows sectional views for illustrating steps in the method of manufacturing the FPC board 1 according to the fifth embodiment.

First, the second laminate L2 of Fig. 12 (d) and the base insulating layer 2 of Fig. 1 are prepared as shown in Fig. 17 (a). Then, the base insulating layer 2 is attached to the second laminate L2 with the adhesive pattern 7 sandwiched therebetween as shown in Fig. 17 (b). After that, the strip layer 7a is stripped together with the pressure sensitive adhesive layer 9a and the carrier layer 9 from the second laminate L2 as shown in Fig. 17 (c). This causes the adhesive pattern 7 to remain on the base insulating layer 2.

Next, the first laminate L1 of Fig. 11 (c) is prepared as shown in Fig. 17 (d). The base insulating layer 2 is then attached to the first laminate L1 with the adhesive pattern 7 sandwiched therebetween as shown in Fig. 17 (e). At this time, the first laminate L1 may be aligned on the base insulating layer 2 using the aligning member 10a of Figs. 15 and 16. In this case, the first laminate L1 is attached to the base insulating layer 2, and the aligning member 10a is then removed. Accordingly, the FPC board 1 is completed.

In the present embodiment, the first laminate L1 and the base insulating layer 2 are joined to each other with the adhesive pattern 7 sandwiched therebetween without preparing the carrier layer 8. This reduces the number of steps in manufacture of the FPC board 1.

### [6] Other Embodiments

While the porous ePTFE is used as the material for the base insulating layer 2 in the above-described embodiments, the present invention is not limited to this. Instead of ePTFE, a porous film of resin containing at least one of epoxy resin, polyimide resin, polyetherimide resin, polyamide-imide resin, polyethylene terephthalate resin, polyethylene naphthalate resin, polybutylene terephthalate resin, polyolefin resin, cycloolefin polymer resin, polyarylate resin, polymethyl methacrylate polymer resin, liquid crystal polymer resin, polycarbonate resin, polyphenylene-sulfide resin, polyether ether ketone resin, polyether sulfone resin, polyacetal resin, polytetrafluoroethylene resin, polyvinylidene fluoride resin, polyester resin, and polyurethane resin may be used as the material for the base insulating layer 2, for example.

While copper is used as the material for the conductor layer 30, the present invention is not limited to this. For example, another metal such as gold (Au), silver or aluminum or an alloy such as a copper alloy, a gold alloy, a silver alloy or an aluminum alloy may be used instead of copper.

While the FPC board 1 includes the five pairs of collector portions (collector portions 3a, 3f, collector portions 3b, 3g, collector portions 3c, 3h, collector portions 3d, 3i and collector portions 3e, 3j) in the above-described embodiments, the present invention is not limited to this. The number of collector portions in the FPC board 1 may be four pairs or less, or may be six pairs or more. This allows any number of electrode films 35 to be connected in series. The FPC board 1 may include one pair of collector portions. In this case, the connection conductor portions 3k to 3n are not provided.

### [7] Correspondences between Elements in the Claims and Parts in Embodiments

In the following paragraphs, non-limiting examples of correspondences between various elements recited in the claims below and those described above with respect to various preferred embodiments of the present invention are explained.

In the above-described embodiments, the base insulating layer 2 is an example of an insulating layer, the adhesive pattern 7 is an example of an adhesive layer and an adhesive pattern, the adhesive layer precursor 7p is an example of an adhesive layer, the conductor layer 30 is an example of a conductor layer, the cover layers 6a to 6n or the plating layer 20 is an example of a cover layer, the electrode film 35 is an example of a cell element, and the casing 40 is an example of a housing.

The first insulating portion 2a is an example of a first region, the second insulating portion 2b is an example of a second region, the collector portions 3a to 3e and the drawn-out conductor portion 3o are an example of a first conductor portion, the collector portions 3f to 3j and the drawn-out conductor portion 3p are an example of a second conductor portion, and the bend portion B1 is an example of a bend portion.

The carrier layer 8 is an example of a support layer, the collector portions 3a to 3j, the connection conductor portions 3k to 3n and the drawn-out conductor portions 3o, 3p are an example of a conductor pattern, and the FPC board 1 is an example of a printed circuit board.

As each of various elements recited in the claims, various other elements having configurations or functions described in the claims can be also used.

While preferred embodiments of the present invention have been described above, it is to be understood that variations and modifications will be apparent to those skilled in the art without departing the scope and spirit of the present invention. The scope of the present invention, therefore, is to be determined solely by the following claims.

### [8] Inventive Examples

### (1) Inventive Examples and Comparative Example

In inventive examples 1 to 4 and a comparative example 1, the FPC boards 1 were manufactured based on the foregoing embodiments. Description will be made of methods of manufacturing the FPC boards 1 in the inventive examples 1 to 4 and the comparative example 1.

The adhesive layer precursor 7p in the inventive example 1 was prepared as follows. The adhesive layer precursor 7p whose solid content concentration was 50 % by weight was prepared by dissolving 40 parts by weight of biphenyl-type epoxy resin of epoxy equivalent of 190, 60 parts by weight of bisphenol F-type epoxy resin of epoxy equivalent of 4500, and 9 parts by weight of 4,4-bis[di(β-hydroxyethoxy)phenylsulfinio]phenylsulfide-bis(hexafluoroantimonate) as a photo-acid generating agent in dioxane. The adhesive layer precursor 7p was negative photosensitive.

The FPC board 1 of the inventive example 1 was manufactured based on the method of manufacturing the FPC board 1 according to the first embodiment. In the FPC board 1 of the inventive example 1, the foregoing adhesive layer precursor 7p was applied on the entire surface including the upper surfaces (surfaces not in contact with the carrier layer 8) of the collector portions 3a to 3j, the connection conductor portions 3k to 3n and the drawn-out conductor portions 3o, 3p in condition at a temperature of 90 °C, a pressure of 0.4 MPa and speed of 1 m/min in the step shown in Fig. 3 (b). Next, the upper surface (surface not in contact with the collector portions 3a to 3j, the connection conductor portions 3k to 3n and the drawn-out conductor portions 3o, 3p) of the adhesive layer precursor 7p was irradiated with ultraviolet rays of 800 mJ/cm² with the mask pattern having the inverted shape of the collector portions 3a to 3j, the connection conductor portions 3k to 3n and the drawn-out conductor portions 3o, 3p sandwiched therebetween, followed by curing treatment for 10 minutes at a temperature of 90 °C in the step shown in Fig. 3 (c). After that, the adhesive layer precursor 7p was developed for 9 minutes using a development solution produced by adding TMAH (tetramethyl ammonium hydroxide) by 1.2 % in a mixed solvent of water and ethanol whose weight ratio was 1: 1, so that the adhesive pattern 7 having the given pattern was formed.

The collector portions 3a to 3j, the connection conductor portions 3k to 3n and the drawn-out conductor portions 3o, 3p were subsequently joined to the base insulating layer 2 made of ePTFE (NTF-1122 by Nitto Denko Co., Ltd.) for 30 minutes in condition at a temperature of 100 °C and a pressure of 5 MPa with the adhesive pattern 7 sandwiched therebetween, followed by curing treatment for 180 minutes at a temperature of 150 °C in the step shown in Fig.3 (d). Finally, the carrier layer 8 was stripped from the collector portions 3a to 3j, the connection conductor portions 3k to 3n and the drawn-out conductor portions 3o, 3p in the step shown in Fig. 4 (a).

The adhesive layer precursor 7p in the inventive example 2 was prepared as follows. A polyimide precursor solution was prepared by dissolving 67 % by weight of ethylene glycol bistrimellitic acid dianhydride as a dianhydride component, 32 % by weight of 1,12-diaminodecane as a diamine component, and 1 % by weight of 1,3-bis-(3-aminopropyl)tetramethyldisiloxane in N,N-dimethylacetamide, followed by reaction for five hours at a room temperature. Here, total concentration of the dianhydride component and the diamine component was 30 % by weight. 1-ethyl-3,5-dimethoxycarbonyl-4-(2-nitrophenyl)-1,4-dihydropyridine as a sensitizing agent was added in the polyimide precursor solution. The concentration of the added sensitizing agent was 15 % by weight with respect to the solid content of the solution. Then, the sensitizing agent was uniformly dissolved in the solution, so that the adhesive layer precursor 7p made of photosensitive polyimide was prepared. The adhesive layer precursor 7p was negative photosensitive.

The FPC board 1 of the inventive example 2 was manufactured based on the method of manufacturing the FPC board 1 according to the second embodiment. In the FPC board 1 of the inventive example 2, the foregoing adhesive layer precursor 7p was applied on the entire upper surface (surface not in contact with the carrier layer 8) of the conductor layer 30 in condition at a temperature of 90 °C, a pressure of 0.4 MPa and speed of 1 m/min in the step shown in Fig. 7 (b).

The upper surface (surface not in contact with the collector portions 3a to 3j, the connection conductor portions 3k to 3n and the drawn-out conductor portions 3o, 3p) of the adhesive layer precursor 7p was irradiated with ultraviolet rays of 3000 mJ/cm² with the mask pattern having the inverted shape of the collector portions 3a to 3j, the connection conductor portions 3k to 3n and the drawn-out conductor portions 3o, 3p sandwiched therebetween, followed by curing treatment for 10 minutes at a temperature of 135 °C in the step shown in Fig. 7 (c). After that, the adhesive layer precursor 7p was developed for 6 minutes using a development solution made of N-methyl-2-pyrolidone, so that the adhesive pattern 7 having the given pattern was formed.

The collector portions 3a to 3j, the connection conductor portions 3k to 3n and the drawn-out conductor portions 3o, 3p were joined to the base insulating layer 2 made of ePTFE (NTF-1122 by Nitto Denko Co., Ltd.) for 30 minutes in condition at a temperature of 200 °C and a pressure of 5 MPa with the adhesive pattern 7 sandwiched therebetween, followed by curing treatment for 60 minutes at a temperature of 200 °C in the step shown in Fig. 8 (a). Finally, the carrier layer 8 was stripped from the collector portions 3a to 3j, the connection conductor portions 3k to 3n and the drawn-out conductor portions 3o, 3p in the step shown in Fig. 8 (b).

The adhesive layer precursor 7p in the inventive example 3 was prepared as follows. A polyimide precursor solution was prepared by dissolving substantially equimolar amounts of 3,3',4,4'-biphenyltetracarboxylic dianhydride as a dianhydride component and 4,4'-diaminodiphenylsulfone as a diamine component in N,N-dimethylacetamide, followed by reaction for 24 hours at a room temperature. Here, total concentration of the dianhydride component and the diamine component was 30 % by weight. A vinyl ether compound represented by the following formula (1) was added and mixed in the polyimide precursor solution. Here, the added amount of the vinyl ether compound was 40 parts by weight with respect to 100 parts by weight of a solid content of a solution. Then, diphenyliodonium-8-anilinonaphthalene-l-sulfonate as a photodegradable proton generating agent was added and mixed in the polyimide precursor solution. Here, the added amount of the photodegradable proton generating agent was 10 parts by weight with respect to 100 parts by weight of the solid content of the solution. After that, the vinyl ether compound and the photodegradable proton generating-agent were uniformly dissolved in the solution, so that the adhesive layer precursor 7p made of photosensitive polyimide was prepared. The adhesive layer precursor 7p was positive photosensitive.

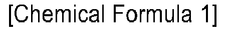

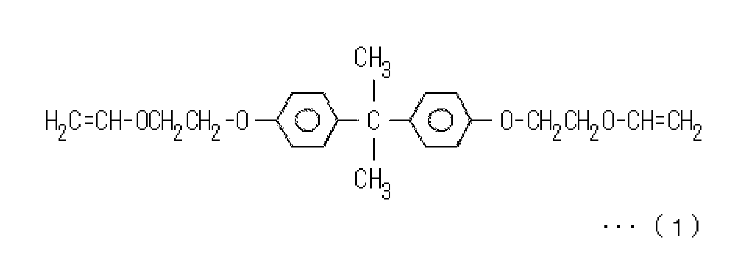

The FPC board 1 of the inventive example 3 was manufactured based on the method of manufacturing the FPC board 1 according to the first embodiment. In the FPC board of the inventive example 3, the foregoing adhesive layer precursor 7p was applied on the entire surface including the upper surfaces (surfaces not in contact with the carrier layer 8) of the collector portions 3a to 3j, the connection conductor portions 3k to 3n and the drawn-out conductor portions 3o, 3p in the step shown in Fig. 3 (b), and dried for 10 minutes at a temperature of 100 °C.

Then, the lower surface (surface in contact with the collector portions 3a to 3j, the connection conductor portions 3k to 3n and the drawn-out conductor portions 3o, 3p) of the adhesive layer precursor 7p was irradiated with ultraviolet rays of 3000 mJ/cm², followed by curing treatment for 10 minutes at a temperature of 110 °C in the step shown in Fig. 3 (c). After that, the adhesive layer precursor 7p was developed for 9 minutes using a development solution made of 1.5 % by weight of a TMAH aqueous solution, so that the adhesive pattern 7 having the given pattern was formed.

The collector portions 3a to 3j, the connection conductor portions 3k to 3n and the drawn-out conductor portions 3o, 3p were subsequently joined to the base insulating layer 2 made of ePTFE (NTF-1122 by Nitto Denko Co., Ltd.) for 30 minutes in condition at a temperature of 200 °C and a pressure of 5 MPa with the adhesive pattern 7 sandwiched therebetween, followed by curing treatment for 120 minutes at a temperature of 200 °C in the step shown in Fig.3 (d). Finally, the carrier layer 8 was stripped from the collector portions 3a to 3j, the connection conductor portions 3k to 3n and the drawn-out conductor portions 3o, 3p in the step shown in Fig. 4 (a).

The adhesive layer precursor 7p in the inventive example 4 was prepared as follows. 80 parts by weight of epoxy resin (jER-1007 by Japan Epoxy Resin Co., Ltd.) dissolved in MEK (Methyl Ethyl Ketone), 20 parts by weight of epoxy resin (YL-7410 by Japan Epoxy Resin Co., Ltd.), 8 parts by weight of acid anhydride (MH-700 by New Japan Chemical Co., Ltd.) which was a curing agent and 2 parts by weight of imidazole (2E4MZ by Shikoku Chemicals Corporation) which was a catalyst were mixed, so that the adhesive layer precursor 7p was prepared. The adhesive layer precursor 7p was not photosensitive.

The FPC board 1 of the inventive example 4 was manufactured based on the method of manufacturing the FPC board 1 according to the third embodiment. In the FPC board 1 of the inventive example 4, the adhesive layer precursor 7p was applied on the entire surface including the upper surfaces (surfaces not in contact with the carrier layer 8) of the collector portions 3a to 3j, the connection conductor portions 3k to 3n and the drawn-out conductor portions 3o, 3p by lamination, and then dried, so that the adhesive layer 7q was formed in the step shown in Fig. 9 (a). After that, the collector portions 3a to 3j, the connection conductor portions 3k to 3n and the drawn-out conductor portions 3o, 3p were joined to the base insulating layer 2 made of ePTFE (NTF-1122 by Nitto Denko Co., Ltd.) for 30 minutes in condition at a temperature of 100 °C and a pressure of 5 MPa with the adhesive layer 7q sandwiched therebetween, followed by curing treatment for 180 minutes at a temperature of 150 °C.

The carrier layer 8 was subsequently stripped from the collector portions 3a to 3j, the connection conductor portions 3k to 3n and the drawn-out conductor portions 3o, 3p in the step shown in Fig. 9 (b). Finally, the exposed adhesive layer 7q that was not covered with the collector portions 3a to 3j, the connection conductor portions 3k to 3n and the drawn-out conductor portions 3o, 3p was removed by plasma processing, thereby forming the adhesive pattern 7 in the step shown in Fig. 9 (c).

The adhesive layer precursor 7p in the comparative example 1 was prepared in the same manner as the adhesive layer precursor 7p in the inventive example 4.

The FPC board 1 of the comparative example 1 was manufactured based on the method of manufacturing the FPC board 1 according to the third embodiment. The steps in the method of manufacturing the FPC board 1 in the comparative example 1 were the same as those in the method of manufacturing the FPC board 1 in the inventive example 4 except for the step shown in Fig. 9 (c), that is, except that the step of removing the exposed region of the adhesive layer 7q that was not covered with the collector portions 3a to 3j, the connection conductor portions 3k to 3n and the drawn-out conductor portions 3o, 3p by plasma processing was not provided.

### (2) Application of the FPC Board to the Fuel Cell

The fuel cells 100 as in Fig. 6 were prepared using the respective FPC boards 1 of the inventive examples 1 to 4 and the comparative example 1. In each of the fuel cells 100 including the respective FPC boards 1 of the inventive examples 1 to 4, it was possible to supply electric power from the fuel cell 100 to an external circuit. Thus, it was confirmed that the base insulating layer 2 sufficiently functioned as the gas-liquid separation membrane.

On the other hand, in the fuel cell 100 including the FPC board 1 of the comparative example 1, it was not possible to supply electric power from the fuel cell 100 to the external circuit. In the FPC board 1 of the comparative example 1, it was not confirmed that the base insulating layer 2 functioned as the gas-liquid separation membrane because of the adhesive layer 7q existing on the entire surface of the air-permeable base insulating layer 2.

## Claims

1. A printed circuit board used in a fuel cell, comprising:
an insulating layer that is made of a porous material;
an adhesive layer provided on said insulating layer; and
a conductor layer provided on said adhesive layer, wherein
said conductor layer and said adhesive layer have the same patterns or different patterns.

2. The printed circuit board according to claim 1, wherein the patterns of said conductor layer and said adhesive layer are formed such that said conductor layer and said adhesive layer have a common opening.

3. The printed circuit board according to claim 1 or 2, wherein
said insulating layer has one surface and the other surface, and has a first region and a second region that are adjacent to each other on said one surface,
said insulating layer can be bent at a bend portion between said first region and said second region such that said first region and said second region are opposite to each other, and
said conductor layer includes
a first conductor portion formed in said first region of said insulating layer, and
a second conductor portion formed in said second region of said insulating layer.

4. The printed circuit board according to any one of the previous claims, further comprising a conductive cover layer that covers a surface of said conductor layer.

5. The printed circuit board according to claim 4, wherein
said conductor layer has first and second main surfaces and side surfaces,
said cover layer is formed on each of said first and second main surfaces and said side surfaces of said conductor layer, and
said conductor layer is provided on said insulating layer such that said cover layer is sandwiched between said first main surface and said insulating layer.

6. The printed circuit board according to any one of the previous claims, wherein said adhesive layer is made of a photosensitive material.

7. A fuel cell comprising:
a printed circuit board;
a cell element; and
a housing that accommodates said printed circuit board and said cell element, wherein
said printed circuit board includes:
an insulating layer that is made of a porous material;
an adhesive layer provided on said insulating layer; and
a conductor layer provided on said adhesive layer,
said conductor layer and said adhesive layer have the same patterns or different patterns,
said insulating layer has one surface and the other surface, and has a first region and a second region that are adjacent to each other on said one surface,
said insulating layer can be bent at a bend portion between said first region and said second region such that said first region and said second region are opposite to each other,
said conductor layer includes
a first conductor portion formed in said first region of said insulating layer, and
a second conductor portion formed in said second region of said insulating layer, and
said cell element is arranged between said first conductor portion and said second conductor portion while said first region and said second region of said insulating layer of said printed circuit board are bent along said bend portion with said one surface as an inner side.

8. A method of manufacturing a printed circuit board used in a fuel cell, comprising the steps of:
preparing a base material having a laminated structure of a support layer and a conductor layer;
forming a conductor pattern having a given pattern on one surface of said support layer by processing said conductor layer;
forming an adhesive pattern made of an adhesive layer having the same pattern as or a different pattern from the pattern of said conductor layer on said conductor pattern;
joining an insulating layer that is made of a porous material on said conductor pattern with said adhesive pattern sandwiched between said insulating layer and said conductor pattern; and
stripping said support layer from said conductor pattern.

9. The method of manufacturing the printed circuit board according to claim 8, wherein
said adhesive layer is photosensitive,
said step of forming said adhesive pattern includes the steps of
forming said adhesive layer on said support layer to cover said conductor pattern, and forming said adhesive pattern by subjecting said adhesive layer to exposure processing and development processing.

10. A method of manufacturing a printed circuit board used in a fuel cell, comprising the steps of:
preparing a base material having a laminated structure of a support layer and a conductor layer;
forming an adhesive pattern composed of an adhesive layer having a given pattern on said conductor layer;
forming said conductor pattern by removing an exposed region of said conductor layer using said adhesive pattern as a mask;
joining an insulating layer that is made of a porous material on said conductor pattern with said adhesive pattern sandwiched between said insulating layer and said conductor pattern; and
stripping said support layer from said conductor pattern.

11. The method of manufacturing the printed circuit board according to claim 10, wherein
said adhesive layer is photosensitive, and
said step of forming said adhesive pattern on said conductor layer includes the step of forming said adhesive pattern by subjecting said adhesive layer to exposure processing and development processing.

12. A method of manufacturing a printed circuit board used in a fuel cell, comprising the steps of:
preparing a base material having a laminated structure of a support layer and a conductor layer;
forming said conductor pattern on one surface of the support layer by processing said conductor layer;
forming a laminated structure of an adhesive layer and an insulating layer that is made of a porous material on said conductor pattern;
stripping said support layer from said conductor pattern; and
forming an adhesive pattern having a given pattern by removing an exposed region of said adhesive layer that does not overlap said conductor pattern after stripping said support layer.

13. The method of manufacturing the printed circuit board according to claim 12, wherein
said step of removing the exposed region of said adhesive layer that does not overlap said conductor pattern includes the step of removing said exposed region of said adhesive layer using plasma.
